# EUROPEAN PATENT APPLICATION

(11) **EP 4 355 055 A1**
(43) Date of publication of application: **17.04.2024**
(21) Application number: 23202956.1
(22) Date of filing: 11.10.2023
(51) Int. Cl.: H10K 59/10, H01L 25/075, H01L 33/62, H10K 59/82, H10K 77/10

(54) **DISPLAY DEVICE**

(30) Priority: 12.10.2022 KR 20220130353
(71) Applicant: LG Display Co., Ltd., Seoul 07336 (KR)
(72) Inventor: JEONG, YuRa, 10845 Paju-si (KR); MIN, SungJoon, 10845 Paju-si (KR); JUNG, HaeYoon, 10845 Paju-si (KR); HAM, Sujin, 10845 Paju-si (KR); LIM, MyungSub, 10845 Paju-si (KR); KIM, Heewon, 10845 Paju-si (KR)
(74) Representative: Beal, James Michael

(57) **Abstract**

A display device according to an exemplary embodiment of the present disclosure may include a lower substrate that is stretchable; a first adhesive layer disposed on the lower substrate; a pattern layer disposed on the first adhesive layer and including a plurality of first line patterns; a plurality of connection lines disposed on each of the plurality of first line patterns; and a filling layer covering the pattern layer and the plurality of connection lines, wherein the plurality of first line patterns include grooves disposed in lower portions thereof, so that the plurality of first line patterns and the plurality of connection lines are separated from the first adhesive layer and easily stretched.

## Description

### CROSS-REFERENCE TO RELATED APPLICATIONS

This application claims the benefit of and priority to Korean Patent Application No. 10-2022-0130353 filed on October 12, 2022, in the Republic of Korea.

### BACKGROUND

### Technical Field

The present disclosure relates to a display device, and more particularly, to a stretchable display device in which stretching reliability of stretched lines is improved.

### Description of the Related Art

Display devices used for a computer monitor, a TV, a mobile phone, and the like include an organic light emitting display (OLED) that emits light by itself, a liquid-crystal display (LCD) that requires a separate light source, and the like.

Such display devices are being applied to more and more various fields including not only a computer monitor and a TV, but personal mobile devices, and thus, display devices having a reduced volume and weight while having a wide active area are being studied.

Recently, a display device manufactured to be stretchable in a specific direction and changeable into various shapes by forming a display unit, lines, and the like on a flexible substrate such as plastic that is a flexible material has received considerable attention as a next-generation display device.

### BRIEF SUMMARY

An aspect of the present disclosure is to provide a display device with improved stretching reliability of line units.

Another aspect of the present disclosure is to provide a display device in which stress of line units is reduced during stretching.

Still another aspect of the present disclosure is to provide a display device in which interference applied to line units is reduced during stretching by covering the line units with a liquid material.

Still another aspect of the present disclosure is to provide a display device in which deformation sections of line units are improved by designing the line units in various structures.

The technical benefits of the present disclosure are not limited to the above-mentioned benefits, and other benefits, which are not mentioned above, can be clearly understood by those skilled in the art from the following descriptions.

A display device according to an exemplary embodiment of the present disclosure may include a lower substrate that is stretchable and includes an active area and a non-active area; a first adhesive layer disposed on the lower substrate; a pattern layer disposed on the first adhesive layer and including a plurality of first plate patterns and a plurality of first line patterns overlapping the active area; a plurality of sub-pixels disposed on each of the plurality of first plate patterns; a plurality of connection lines disposed on each of the plurality of first line patterns; and a filling layer including a first filling layer filled in the active area and covering the pattern layer, the plurality of sub-pixels, and the plurality of connection lines, wherein the plurality of first line patterns include grooves disposed in lower portions thereof, so that the first adhesive layer and the plurality of first line patterns are spaced apart from each other. Accordingly, the plurality of first line patterns and the plurality of connection lines are separated from the first adhesive layer and configured to float inside the filling layer. Thus, the plurality of first line patterns and the plurality of connection lines can be easily stretched without being interfered with by other components, and stretching reliability can also be improved.

A display device according to an exemplary embodiment of the present disclosure may include a lower substrate that is stretchable and includes an active area and a non-active area; a plurality of first plate patterns disposed on the lower substrate and overlapping the active area; a plurality of sub-pixels disposed on each of the plurality of first plate patterns; and a plurality of line units disposed between the plurality of first plate patterns, wherein the plurality of line units include a plurality of linear portions formed in a linear shape and a plurality of semicircular portions formed in a semicircular shape.

Other detailed matters of the exemplary embodiments are included in the detailed description and the drawings.

According to the present disclosure, stretching reliability of line units can be improved by floating the line units in a liquid material.

According to the present disclosure, it is possible to improve a stretching rate while reducing stress of line units by reducing interference applied to the line units.

According to the present disclosure, stretchability of a display device can be improved by designing line units in various structures and increasing a length of a deformed portion compared to an overall length of the line unit.

The effects according to the present disclosure are not limited to the contents exemplified above, and more various effects are included in the present specification.

### BRIEF DESCRIPTION OF THE SEVERAL VIEWS OF THE DRAWINGS

FIG. 1 is a plan view of a display device according to an exemplary embodiment of the present disclosure.
FIG. 2 is an enlarged plan view of an active area of the display device according to an exemplary embodiment of the present disclosure.
FIG. 3 is a cross-sectional view taken along III-III' of FIG. 2.
FIG. 4 is a cross-sectional view taken along IV-IV' of FIG. 2.
FIG. 5 is a cross-sectional view taken along V-V' of FIG. 2.
FIGS. 6A to 6D are process views for explaining a method of manufacturing the display device according to an exemplary embodiment of the present disclosure.
FIGS. 7A to 7C are process views for explaining a method of manufacturing the display device according to an exemplary embodiment of the present disclosure.
FIG. 8 is a schematic cross-sectional view of the display device according to an exemplary embodiment of the present disclosure.
FIGS. 9A, 9B, 9C, 9D to 12 are enlarged plan views of display devices according to various exemplary embodiments of the present disclosure.
FIGS. 13A and 13B are views illustrating deformation sections of line units when display devices according to Comparative Example and Example of the present disclosure are stretched.
FIGS. 14 to 16 are enlarged plan views of display devices according to various exemplary embodiments of the present disclosure.

### DETAILED DESCRIPTION

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure.

The shapes, sizes, dimensions (e.g., length, width, height, thickness, radius, diameter, area, etc.), ratios, angles, number of elements, and the like illustrated in the accompanying drawings for describing the exemplary embodiments of the present disclosure are merely examples, and the present disclosure is not limited thereto.

A dimension including size and a thickness of each component illustrated in the drawing are illustrated for convenience of description, and the present disclosure is not limited to the size and the thickness of the component illustrated, but it is to be noted that the relative dimensions including the relative size, location, and thickness of the components illustrated in various drawings submitted herewith are part of the present disclosure.

Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on," "above," "below," and "next," one or more parts may be positioned between the two parts unless the terms are used with the term "immediately" or "directly."

When an element or layer is disposed "on" another element or layer, another layer or another element may be interposed directly on the other element or therebetween.

Although the terms "first," "second," and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a display device according to exemplary embodiments of the present disclosure will be described in detail with reference to accompanying drawings.

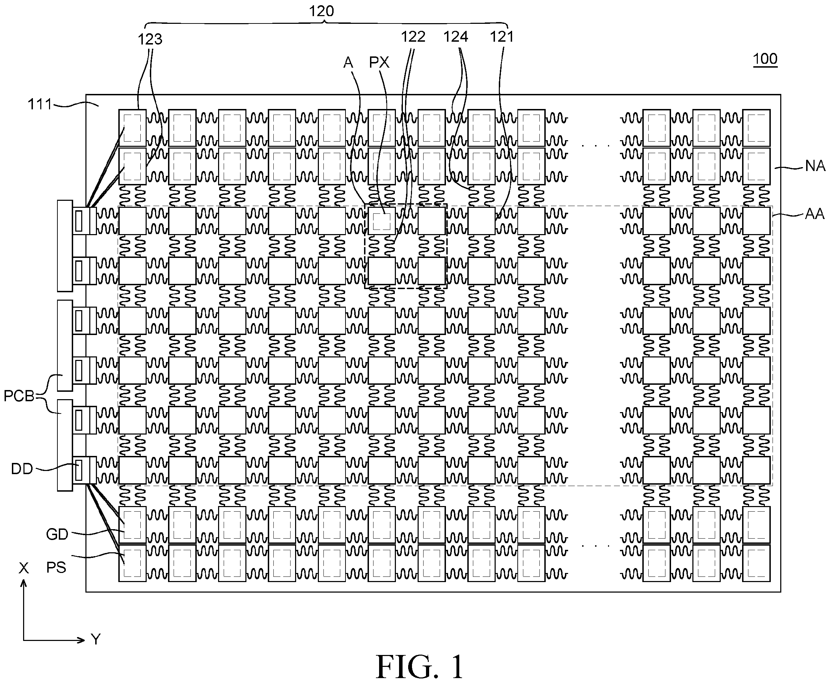

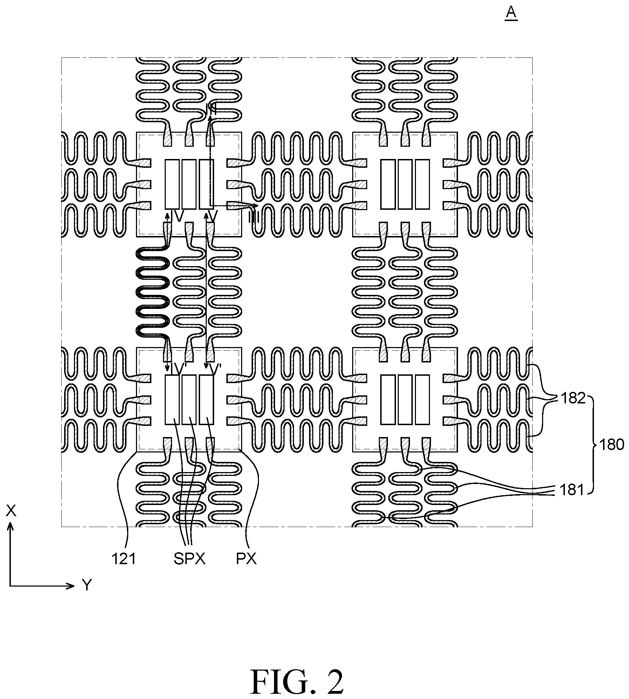

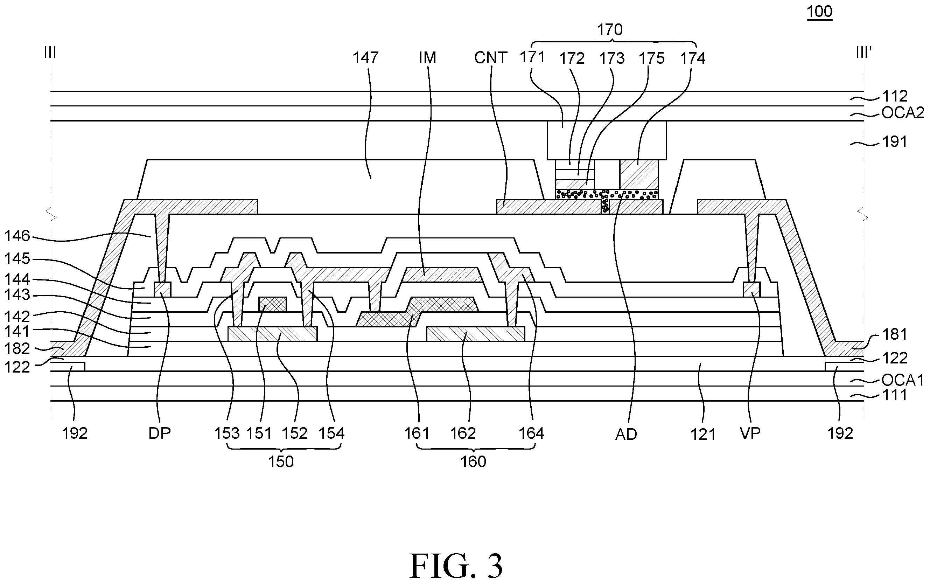

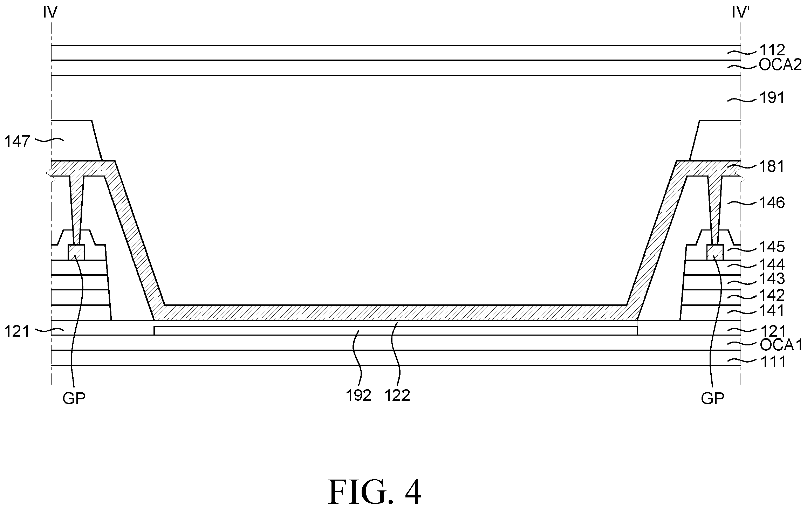

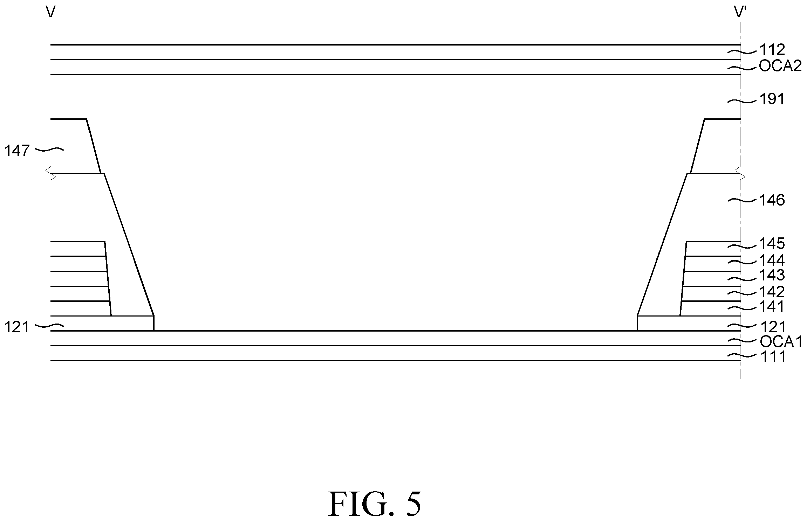

FIG. 1 is a plan view of a display device according to an exemplary embodiment of the present disclosure. FIG. 2 is an enlarged plan view of an active area of the display device according to an exemplary embodiment of the present disclosure. FIG. 3 is a cross-sectional view taken along III-III' of FIG. 2. FIG. 4 is a cross-sectional view taken along IV-IV' of FIG. 2. FIG. 5 is a cross-sectional view taken along V-V' of FIG. 2.

First, a display device 100 according to an exemplary embodiment of the present disclosure is a display device capable of displaying an image even if it is bent or stretched, and may also be referred to a stretchable display device or a flexible display device. The display device 100 may have higher flexibility and stretchability than conventional, typical display devices. Accordingly, a user can bend or stretch the display device 100, and a shape of the display device 100 can be freely changed according to the user's manipulation. For example, when the user grabs and pulls an end of the display device 100, the display device 100 may be stretched in a pulling direction by the user. If the user places the display device 100 on an uneven outer surface, the display device 100 can be disposed to be bent according to a shape of the outer surface. When force applied by the user is removed, the display device 100 can return to an original shape thereof.

Referring to FIGS. 1 to 3 together, a lower substrate 111 is a substrate for supporting and protecting various components of the display device 100. In addition, the lower substrate 111 may support a pattern layer 120 on which pixels PX, gate drivers GD, and power supplies PS are formed.

In addition, an upper substrate 112 is a substrate for covering and protecting various components of the display device 100. The upper substrate 112 may cover the pixels PX, the gate drivers GD, and the power supplies PS.

Each of the lower substrate 111 and the upper substrate 112 is a ductile substrate and may be formed of an insulating material that can be bent or stretched. For example, each of the lower substrate 111 and the upper substrate 112 may be formed of silicone rubber such as polydimethylsiloxane (PDMS) or elastomers such as polyurethane (PU) and polytetrafluoroethylene (PTFE), and thus, may have flexible properties. In addition, materials of the lower substrate 111 and the upper substrate 112 may be the same, but are not limited thereto and may be variously modified.

Each of the lower substrate 111 and the upper substrate 112 is a ductile substrate and may be reversibly expandable and contractible. Accordingly, the lower substrate 111 may be referred to as a lower stretchable substrate, a lower flexible substrate, a lower extendable substrate, a lower ductile substrate, a first stretchable substrate, a first flexible substrate, a first extendable substrate, or a first ductile substrate, and the upper substrate 112 may be referred to as an upper stretchable substrate, an upper flexible substrate, an upper extendable substrate, an upper ductile substrate, a second stretchable substrate, a second flexible substrate, a second extendable substrate, or a second ductile substrate.

Moduli of elasticity of the lower substrate 111 and the upper substrate 112 may be several MPa to several hundreds of MPa. Further, a ductile breaking rate of the lower substrate 111 and the upper substrate 112 may be 100% or higher. Here, the ductile breaking rate refers to a stretching rate at a point in time at which an object being stretched is broken or cracked. A thickness of the lower substrate may be 10 µm to 1 mm, but is not limited thereto.

The lower substrate 111 may have an active area AA and a non-active area NA surrounding the active area AA. However, the active area AA and the non-active area NA are not limited only to the lower substrate 111 and may be referred throughout the display device 100.

The active area AA is an area in which an image is displayed on the display device 100. A plurality of the pixels PX are disposed in the active area AA. In addition, each of the pixels PX may include a display element and various driving elements for driving the display element. The various driving elements may mean at least one thin film transistor TFT and a capacitor, but the present disclosure is not limited thereto. Each of the plurality of pixels PX may be driven by being connected to various lines. For example, each of the plurality of pixels PX may be connected to various lines such as gate lines, data lines, high potential voltage lines, low potential voltage lines, reference voltage lines, and initialization voltage lines.

The non-active area NA is an area in which an image is not displayed. The non-active area NA may be an area adjacent to the active area AA. For example, the non-active area NA may be an area surrounding the active area AA. However, the present disclosure is not limited thereto, and the non-active area NA corresponds to an area of the lower substrate 111 excluding the active area AA and may be changed and separated into various shapes. Components for driving the plurality of pixels PX disposed in the active area AA, for example, the gate drivers GD and the power supplies PS may be disposed in the non-active area NA. In addition, a plurality of pads that are connected to the gate drivers GD and the data drivers DD may be disposed in the non-active area NA, and each of the pads may be connected to the plurality of pixels PX in the active area AA.

The pattern layer 120 is disposed on the lower substrate 111. The pattern layer 120 includes a plurality of first plate patterns 121 and a plurality of first line patterns 122 that are disposed in the active area AA and a plurality of second plate patterns 123 and a plurality of second line patterns 124 that are disposed in the non-active area NA.

The plurality of first plate patterns 121 may be disposed in the active area AA of the lower substrate 111, and the plurality of second plate patterns 123 may be disposed in the non-active area NA of the lower substrate 111. The plurality of pixels PX may be formed on the plurality of first plate patterns 121. In addition, the gate drivers GD and the power supplies PS may be formed on the plurality of second plate patterns 123.

The plurality of first plate patterns 121 and the plurality of second plate patterns 123 may be disposed in the form of islands that are spaced apart from each other. Each of the plurality of first plate patterns 121 and the plurality of second plate patterns 123 may be individually separated. Accordingly, the plurality of first plate patterns 121 and the plurality of second plate patterns 123 may be referred to as first island patterns and second island patterns, or first individual patterns and second individual patterns.

Referring to FIG. 1, a size of each of the plurality of second plate patterns 123 may be greater than a size of each of the plurality of first plate patterns 121. One stage of the gate driver GD may be disposed on each of the plurality of second plate patterns 123. Accordingly, since an area that is occupied by various circuit components constituting one stage of the gate driver GD is relatively greater than an area occupied by one pixel PX, the size of each of the plurality of second plate patterns 123 may be greater than the size of each of the first plate patterns 121.

Meanwhile, it is illustrated in FIG. 1 that the plurality of second plate patterns 123 are disposed in the non-active area NA on both sides of the active area AA in a first direction X, but the illustration of FIG. 1 is exemplary. The plurality of second plate patterns 123 may be disposed in any area of the non-active area NA. In addition, although the plurality of first plate patterns 121 and the plurality of second plate patterns 123 are illustrated in quadrangular shapes, the present disclosure is not limited thereto. The plurality of first plate patterns 121 and the plurality of second plate patterns 123 may be changeable in various shapes.

Referring to FIGS. 1 and 2, the plurality of first line patterns 122 of the pattern layer 120 are disposed in the active area AA. The plurality of first line patterns 122 are patterns that connect the first plate patterns 121 adjacent to each other, and may be referred to as internal connection patterns. That is, the plurality of first line patterns 122 are disposed between the plurality of first plate patterns 121.

The plurality of second line patterns 124 of the pattern layer 120 may be disposed in the non-active area NA. The plurality of second line patterns 124 are patterns that connect the first plate patterns 121 and the second plate patterns 123 adjacent to each other or connect the plurality of second plate patterns 123 adjacent to each other. Accordingly, the plurality of second line patterns 124 may be referred to as external connection patterns. The plurality of second line patterns 124 may be disposed between the first plate patterns 121 and the second plate patterns 123 that are adjacent to each other, and disposed between the plurality of second plate patterns 123 that are adjacent to each other.

The plurality of first line patterns 122 and the plurality of second line patterns 124 may have wavy shapes. For example, the plurality of first line patterns 122 and the plurality of second line patterns 124 may have sine wave shapes. However, the shapes of the plurality of first line patterns 122 and the plurality of second line patterns 124 are not limited thereto. For example, the plurality of first line patterns 122 and the plurality of second line patterns 124 may extend in zigzag manners. Alternatively, the plurality of first line patterns 122 and the plurality of the second line patterns 124 may have shapes, such as shapes in which a plurality of rhombus-shaped substrates are extended by being connected at vertices thereof, or may have various shapes such as shapes in which linear, semi-circular and quadrant substrates are connected to each other. In addition, the numbers and shapes of the plurality of first line patterns 122 and the plurality of second line patterns 124 illustrated in FIG. 1 are exemplary, and the numbers and shapes of the plurality of first line patterns 122 and the plurality of second line patterns 124 may be variously changed according to design.

Meanwhile, the plurality of first plate patterns 121, the plurality of first line patterns 122, the plurality of second plate patterns 123, and the plurality of second line patterns 124 are rigid patterns. That is, the plurality of first plate patterns 121, the plurality of first line patterns 122, the plurality of second plate patterns 123, and the plurality of second line patterns 124 may have rigid properties compared to the lower substrate 111 and the upper substrate 112.

The plurality of first plate patterns 121, the plurality of first line patterns 122, the plurality of second plate patterns 123, and the plurality of second line patterns 124 that are rigid substrates may be formed of a plastic material having flexibility lower than that of the lower substrate 111 and the upper substrate 112. For example, the plurality of first plate patterns 121, the plurality of first line patterns 122, the plurality of second plate patterns 123, and the plurality of second line patterns 124 may be formed of at least one material among polyimide (PI), polyacrylate, and polyacetate. In this case, when the plurality of first plate patterns 121, the plurality of first line patterns 122, the plurality of second plate patterns 123, and the plurality of second line patterns 124 are formed of the same material, the plurality of first plate patterns 121, the plurality of first line patterns 122, the plurality of second plate patterns 123, and the plurality of second line patterns 124 may be integrally formed. However, the plurality of first plate patterns 121, the plurality of first line patterns 122, the plurality of second plate patterns 123, and the plurality of second line patterns 124 may be formed of different materials, but the present disclosure is not limited thereto.

Moduli of elasticity of the plurality of first plate patterns 121, the plurality of first line patterns 122, the plurality of second plate patterns 123, and the plurality of second line patterns 124 may be higher than the modulus of elasticity of the lower substrate 111. The modulus of elasticity is a parameter representing a rate of deformation against a stress applied to the substrate. When the modulus of elasticity is relatively high, hardness may be relatively high. Accordingly, the plurality of first plate patterns 121, the plurality of first line patterns 122, the plurality of second plate patterns 123, and the plurality of second line patterns 124 may be referred to as a plurality of first rigid patterns, a plurality of second rigid patterns, a plurality of third rigid patterns, and a plurality of fourth rigid patterns, respectively. The moduli of elasticity of the plurality of first plate patterns 121, the plurality of first line patterns 122, the plurality of second plate patterns 123, and the plurality of second line patterns 124 may be 1000 times higher than the moduli of elasticity of the lower substrate 111 and the upper substrate 112, but the present disclosure is not limited thereto.

Meanwhile, in some embodiments, the lower substrate 111 may be defined as including a plurality of first lower patterns and a second lower pattern. The plurality of first lower patterns may be areas of the lower substrate 111 that overlap the plurality of first plate patterns 121 and the plurality of second plate patterns 123. The second lower pattern may be an area that does not overlap the plurality of first plate patterns 121 and the plurality of second plate patterns 123.

Also, the upper substrate 112 may be defined as including a plurality of first upper patterns and a second upper pattern. The plurality of first upper patterns may be areas of the upper substrate 112 that overlap the plurality of first plate patterns 121 and the plurality of second plate patterns 123. The second upper pattern may be an area that does not overlap the plurality of first plate patterns 121 and the plurality of second plate patterns 123.

In this case, moduli of elasticity of the plurality of first lower patterns and first upper patterns may be higher than moduli of elasticity of the second lower pattern and the second upper pattern. For example, the plurality of first lower patterns and the first upper patterns may be formed of the same material as the plurality of first plate patterns 121 and the plurality of second plate patterns 123, and the second lower pattern and the second upper pattern may be formed of a material having a modulus of elasticity lower than those of the plurality of first plate patterns 121 and the plurality of second plate patterns 123.

For example, the first lower patterns and the first upper patterns may be formed of polyimide (PI), polyacrylate, polyacetate, or the like. The second lower pattern and the second upper pattern may be formed of silicon rubber such as polydimethylsiloxane (PDMS) or an elastomer such as polyurethane (PU) or polytetrafluoroethylene (PTFE).

The gate drivers GD may be mounted on the plurality of second plate patterns 123. The gate drivers GD may be formed on the plurality of second plate patterns 123 in a gate in panel (GIP) method when various components on the plurality of first plate patterns 121 are manufactured. Accordingly, various circuit components constituting the gate drivers GD such as transistors, capacitors, and lines may be disposed on the plurality of second plate patterns 123. One stage that constitutes the gate driver GD and that is a circuit including a transistor, a capacitor, and the like, may be disposed above each of the plurality of second plate patterns 123. However, the gate driver GD may be mounted in a chip on film (COF) method, but the present disclosure is not limited thereto.

The power supplies PS are disposed on the plurality of second plate patterns 123. The power supplies PS may be formed on the second plate patterns 123 adjacent to the gate drivers GD. The power supplies PS are a plurality of power blocks patterned when manufacturing various components on the first plate patterns 121 and may be formed on the second plate patterns 123. The power supplies PS may be electrically connected to the gate drivers GD of the non-active area NA and the plurality of pixels PX of the active area AA to supply a driving voltage. Specifically, the power supplies PS may be electrically connected to the gate drivers GD formed on the second plate patterns 123 and the plurality of pixels PX formed on the first plate patterns 121 through the second line patterns 124 and the first line patterns 122. For example, the power supplies PS may supply a gate driving voltage and a clock signal to the gate drivers GD. Also, the power supply PS may supply a power voltage to each of the plurality of pixels PX.

A printed circuit board PCB is connected to an edge of the lower substrate 111. The printed circuit board PCB is a component that transfers signals and voltages for driving display elements from control units to the display elements. Accordingly, the printed circuit board PCB may also be referred to as a driving board. The control units such as IC chips and circuit units may be mounted on the printed circuit board PCB. In addition, a memory, a processor, and the like may be mounted on the printed circuit board PCB. Also, the printed circuit board PCB provided in the display device 100 may include a stretchable area and a non-stretchable area in order to secure stretchability. An IC chip, a circuit unit, a memory, a processor and the like may also be mounted in the non-stretchable area, and lines electrically connected to the IC chip, the circuit unit, the memory, and the processor may be disposed in the stretchable area.

The data driver DD is a component which supplies a data voltage to the plurality of pixels PX disposed in the active area AA. The data driver DD may be configured in a form of an IC chip and thus, may also be referred to as a data integrated circuit D-IC. Further, the data driver DD may be mounted on the non-stretchable area of the printed circuit board PCB. That is, the data driver DD may be mounted on the printed circuit board PCB in a form of a chip on board (COB). Although in FIG. 1, it is illustrated that the data driver DD is mounted in a chip on board (COB) manner, the data driver DD may be mounted in a method such as a chip on film (COF) method, a chip on glass (COG) method, a tape carrier package (TCP) method, or the like, and the present disclosure is not limited thereto.

Also, although it is illustrated in FIG. 1 that one data driver DD is disposed to correspond to each of a plurality of columns configured by the plurality of first plate patterns 121 disposed in the active area AA, the present disclosure is not limited thereto. That is, one data driver DD may be disposed to correspond to a plurality of columns configured by the plurality of first plate patterns 121.

Referring to FIGS. 1 and 2, the plurality of first plate patterns 121 are disposed on the active area AA of the lower substrate 111 to be spaced apart from each other. For example, the plurality of first plate patterns 121 may be disposed in a matrix form on the lower substrate 111 as illustrated in FIG. 1, but are not limited thereto. Also, the plurality of first line patterns 122 may connect the plurality of first plate patterns 121 to each other. A portion of the plurality of first line patterns 122 may connect the plurality of first plate patterns 121 adjacent to each other in the first direction X, and the other portion of the plurality of first line patterns 122 may connect the plurality of first plate patterns 121 adjacent to each other in the second direction Y.

Referring to FIG. 2 and FIG. 3, the pixels PX including a plurality of sub-pixels SPX, which are individual units emitting light, are disposed on the plurality of first plate patterns 121. Each of the plurality of sub-pixels SPX may include an LED 170, which is a display element and a driving transistor 160 and a switching transistor 150 for driving the LED 170. However, the display element in the sub-pixel SPX is not limited to the LED 170 and may be an organic light emitting diode. Further, the plurality of sub-pixels SPX may include a red sub-pixel, a green sub-pixel, and a blue sub-pixel, but are not limited thereto. Colors of the plurality of sub-pixels SPX may be variously changed as needed.

Hereinafter, a cross-sectional structure of the active area AA will be described in detail with reference to FIG. 3.

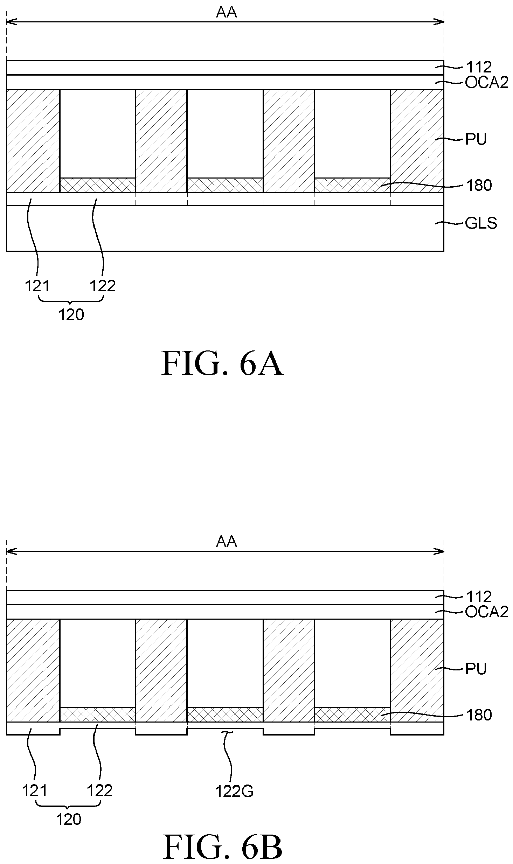

Referring to FIG. 3, a first adhesive layer OCA1 is disposed between the lower substrate 111 and the pattern layer 120. The first adhesive layer OCA1 is a member that bonds the lower substrate 111 and the pattern layer 120 to each other, and may be a transparent adhesive film, for example, optically clear adhesive (OCA). The first adhesive layer OCA1 seals a space between the lower substrate 111 and the upper substrate 112 together with a second adhesive layer OCA2 to be described later, so that a filling layer 190 may be positioned between the lower substrate 111 and the upper substrate 112, and a more detailed description thereof will be described later with reference to FIG. 6A to FIG. 8.

The plurality of first plate patterns 121 and the plurality of first line patterns 122 are disposed on the first adhesive layer OCA1. In this case, lower portions of the plurality of first line patterns 122 may be patterned to have grooves 122G formed therein. A thickness of the plurality of first line patterns 122 having the grooves 122G formed in the lower portions thereof may be less than that of the plurality of first plate patterns 121. In other words, the tops of the first plate patterns 121 and the tops of the first line patterns 122 may be level with each other, i.e. may be at a same vertical distance from the lower substrate 111. However, due to the grooves 122G in the lower portions of the first line patterns 122, the bottoms of the first plate patterns 121 may be a smaller vertical distance from the lower substrate 111 than the vertical distance between the bottoms of the first line patterns 122 and the lower substrate 111. The plurality of first plate patterns 121 are bonded to the first adhesive layer OCA1, but the plurality of first line patterns 122 may not be bonded to the first adhesive layer OCA1 through the grooves 122G. In this case, when the display device 100 is stretched, the plurality of first line patterns 122 can be more easily stretched without being interfered with by the first adhesive layer OCA1. Therefore, by forming the grooves 122G in the lower portions of the plurality of first line patterns 122 to separate the first adhesive layer OCA1 from the first line patterns 122, the plurality of first line patterns 122 and a plurality of connection lines 180 may be easily stretched when the display device 100 is stretched. Each of the first line patterns 122 may comprise a groove 122G formed therein. The grooves 122G may be referred to as being formed in the lower portions of the first line patterns 122 or in the lower surfaces or the lower sides of the first line patterns 122. Here, 'lower' is used to indicate a portion, side or surface of the first line patterns 122 which is closer to the lower substrate 111 than an opposite portion, side or surface of the first line patterns 122. As used herein, the grooves may be referred to as spaces, cavities or voids.

Next, a plurality of inorganic insulating layers are disposed on the plurality of first plate patterns 121. For example, the plurality of inorganic insulating layers may include a buffer layer 141, a gate insulating layer 142, a first interlayer insulating layer 143, a second interlayer insulating layer 144, and a passivation layer 145. In addition to the inorganic insulating layers described above, other inorganic insulating layers may be further disposed, or one or more of the inorganic insulating layers may be omitted. A configuration of the plurality of inorganic insulating layers is not limited thereto.

First, the buffer layer 141 is disposed on the plurality of first plate patterns 121. The buffer layer 141 is formed on the plurality of first plate patterns 121 to protect various components of the display device 100 from permeation of moisture and oxygen or the like from the outside of the plurality of first plate patterns 121 and the lower substrate 111. The buffer layer 141 may be formed of an insulating material. For example, the buffer layer 141 may be formed as a single layer or multiple layers formed of at least one of silicon nitride (SiNx), silicon oxide (SiOx), and silicon oxynitride (SiON). However, the buffer layer 141 may be omitted depending on a structure or characteristics of the display device 100.

In this case, the buffer layer 141 may be formed only in areas where the lower substrate 111 overlaps the plurality of first plate patterns 121 and the plurality of second plate patterns 123. As described above, since the buffer layer 141 may be formed of an inorganic material, it may be easily damaged, such as being easily cracked, while the display device 100 is stretched. Accordingly, the buffer layer 141 may not be formed in areas between the plurality of first plate patterns 121 and the plurality of second plate patterns 123. The buffer layer 141 may be patterned in shapes of the plurality of first plate patterns 121 and the plurality of second plate patterns 123 and formed only on upper portions of the plurality of first plate patterns 121 and the plurality of second plate patterns 123. Accordingly, in the display device 100 according to an exemplary embodiment of the present disclosure, the buffer layer 141 is formed only in the area where the buffer layer 141 overlaps the plurality of first plate patterns 121 and the plurality of second plate patterns 123 which are rigid substrates, so that damage to various components of the display device 100 may be prevented even when the display device 100 is deformed, such as being bent or stretched.

Referring to FIG. 3, the switching transistor 150 including a gate electrode, an active layer, a source electrode, and a drain electrode, and the driving transistor 160 including a gate electrode, an active layer, a source electrode, and a drain electrode are formed on the buffer layer 141.

First, referring to FIG. 1, a switching active layer 152 of the switching transistor 150 and a driving active layer 162 of the driving transistor 160 are disposed on the buffer layer 141. For example, each of the switching active layer 152 of the switching transistor 150 and the driving active layer 162 of the driving transistor 160 may be formed of an oxide semiconductor. Alternatively, the switching active layer 152 of the switching transistor 150 and the driving active layer 162 of the driving transistor 160 may be formed of amorphous silicon (a-Si), polycrystalline silicon (poly-Si), an organic semiconductor or the like.

The gate insulating layer 142 is disposed on the switching active layer 152 of the switching transistor 150 and the driving active layer 162 of the driving transistor 160. The gate insulating layer 142 is a layer to electrically insulate a switching gate electrode 151 of the switching transistor 150 from the switching active layer 152 of the switching transistor 150 and electrically insulate a driving gate electrode 161 of the driving transistor 160 from the driving active layer 162 of the driving transistor 160. The gate insulating layer 142 may be formed of an insulating material. For example, the gate insulating layer 142 may be formed as a single layer of silicon nitride (SiNx) or silicon oxide (SiOx) or multiple layers of silicon nitride (SiNx) or silicon oxide (SiOx), but is not limited thereto.

The switching gate electrode 151 of the switching transistor 150 and the driving gate electrode 161 of the driving transistor 160 are disposed on the gate insulating layer 142. The switching gate electrode 151 and the driving gate electrode 161 are disposed on the gate insulating layer 142 to be spaced apart from each other. Further, the switching gate electrode 151 overlaps the switching active layer 152, and the driving gate electrode 161 overlaps the driving active layer 162.

Each of the switching gate electrode 151 and the driving gate electrode 161 may be formed of any one of various metallic materials, for example, any one of molybdenum (Mo), aluminum (Al), chromium (Cr), gold (Au), titanium (Ti), nickel (Ni), neodymium (Nd) and copper (Cu). Alternatively, each of the switching gate electrode 151 and the driving gate electrode 161 may be formed of an alloy of two or more of the metallic materials, or multiple layers thereof. However, the present disclosure is not limited thereto.

The first interlayer insulating layer 143 is disposed on the switching gate electrode 151 and the driving gate electrode 161. The first interlayer insulating layer 143 insulates the driving gate electrode 161 from an intermediate metal layer IM. The first interlayer insulating layer 143 may be formed of an inorganic material like the buffer layer 141. For example, the first interlayer insulating layer 143 may be formed as a single layer of silicon nitride (SiNx) or silicon oxide (SiOx) or multiple layers of silicon nitride (SiNx) or silicon oxide (SiOx), but is not limited thereto.

The intermediate metal layer IM is disposed on the first interlayer insulating layer 143. The intermediate metal layer IM overlaps the gate electrode of the driving transistor 160 to form a storage capacitor. However, the intermediate metal layer IM may overlap another electrode to form a storage capacitor in various manners, but the present disclosure is not limited thereto.

The intermediate metal layer IM may be formed of any one of various metallic materials, for example, any one of molybdenum (Mo), aluminum (Al), chromium (Cr), gold (Au), titanium (Ti), nickel (Ni), neodymium (Nd) and copper (Cu). Alternatively, the intermediate metal layer IM may be formed of an alloy of two or more of the metallic materials, or multiple layers thereof. However, the present disclosure is not limited thereto.

The second interlayer insulating layer 144 is disposed on the intermediate metal layer IM. The second interlayer insulating layer 144 insulates the switching gate electrode 151 from a switching source electrode 153 and a switching drain electrode 154 of the switching transistor 150. Also, the second interlayer insulating layer 144 insulates the intermediate metal layer IM from a driving source electrode and a driving drain electrode 164 of the driving transistor 160. The second interlayer insulating layer 144 may also be formed of an inorganic material like the buffer layer 141. For example, the second interlayer insulating layer 144 may be formed as a single layer of silicon nitride (SiNx) or silicon oxide (SiOx) or multiple layers of silicon nitride (SiNx) or silicon oxide (SiOx), but is not limited thereto.

The switching source electrode 153 and the switching drain electrode 154 of the switching transistor 150 are disposed on the second interlayer insulating layer 144. Also, the driving source electrode and the driving drain electrode 164 of the driving transistor 160 are disposed on the second interlayer insulating layer 144. The switching source electrode 153 and the switching drain electrode 154 of the switching transistor 150 are disposed on the same layer to be spaced apart from each other. Further, although the driving source electrode of the driving transistor 160 is omitted in FIG. 3, the driving source electrode of the driving transistor 160 may also be disposed on the same layer as the driving drain electrode 164 of the driving transistor 160 to be spaced apart therefrom. The switching source electrode 153 and the switching drain electrode 154 may be electrically connected to the switching active layer 152 through contact holes formed in the gate insulating layer 142, the first interlayer insulating layer 143, and the second interlayer insulating layer 144. The driving source electrode and the driving drain electrode 164 may also be electrically connected to the driving active layer 162 through contact holes formed in the gate insulating layer 142, the first interlayer insulating layer 143, and the second interlayer insulating layer 144. Further, the switching drain electrode 154 of the switching transistor 150 may be electrically connected to the driving gate electrode 161 of the driving transistor 160 through the contact holes of the first interlayer insulating layer 143 and the second interlayer insulating layer 144.

The switching source electrode 153 and the switching drain electrode 154 and the driving source electrode and the driving drain electrode 164 may be formed of any one of various metallic materials, for example, any one of molybdenum (Mo), aluminum (Al), chromium (Cr), gold (Au), titanium (Ti), nickel (Ni), neodymium (Nd) and copper (Cu). Alternatively, the switching source electrode 153 and the switching drain electrode 154 and the driving source electrode and the driving drain electrode 164 may be formed of an alloy of two or more of the metallic materials, or multiple layers thereof. However, the present disclosure is not limited thereto.

Further, in the present disclosure, the driving transistor 160 has been described as having a coplanar structure, but various types of transistors having a staggered structure or the like may also be used. Also, in the present disclosure, the transistor may be formed not only in a top gate structure but also in a bottom gate structure. However, the present disclosure is not limited thereto.

Gate pads GP, data pads DP and a power pad VP may be disposed on the second interlayer insulating layer 144.

First, referring to FIG. 4, the gate pads GP are pads for transferring a gate voltage to the plurality of sub-pixels SPX. The gate pads GP may be electrically connected to a first connection line 181 through contact holes formed in a planarization layer 146 and the passivation layer 145. The gate voltage supplied from the first connection line 181 may be transferred from the gate pads GP to the switching gate electrode 151 of the switching transistor 150 through lines formed on the first plate pattern 121.

Referring to FIG. 3, the data pads DP are pads for transferring a data voltage to the plurality of sub-pixels SPX. The data pad DP may be electrically connected to a second connection line 182 through contact holes formed in the planarization layer 146 and the passivation layer 145. The data voltage supplied from the second connection line 182 may be transferred from the data pad DP to the switching source electrode 153 of the switching transistor 150 through lines formed on the first plate pattern 121.

Referring to FIG. 3, the power pad VP is a pad for transferring a low potential voltage to the plurality of sub-pixels SPX. The power pad VP may be electrically connected to the first connection line 181 through contact holes formed in the planarization layer 146 and the passivation layer 145. Also, the low potential voltage supplied from the first connection line 181 may be transferred from the power pad VP to the LED 170 through lines formed on the first plate pattern 121.

The gate pads GP, the data pads DP, and the power pad VP may be formed of the same material as the source electrode and the drain electrode, for example, any one of molybdenum (Mo), aluminum (Al), chromium (Cr), gold (Au), titanium (Ti), nickel (Ni), neodymium (Nd) and copper (Cu). Alternatively, the gate pads GP, the data pads DP, and the power pad VP may be formed of an alloy of two or more of the materials, or multiple layers thereof. However, the present disclosure is not limited thereto.

Referring to FIG. 3, the passivation layer 145 is formed on the switching transistor 150, the driving transistor 160, the gate pad GP, the data pad DP, and the power pad VP. The passivation layer 145 may protect components under the passivation layer 145 from moisture and oxygen. The passivation layer 145 may be formed of an inorganic material and may be formed as a single layer or multiple layers, but is not limited thereto.

Meanwhile, the gate insulating layer 142, the first interlayer insulating layer 143, the second interlayer insulating layer 144, and the passivation layer 145 may be patterned in the same manner as the buffer layer 141 and formed only in areas where they overlap the plurality of first plate patterns 121. Since the gate insulating layer 142, the first interlayer insulating layer 143, the second interlayer insulating layer 144, and the passivation layer 145 may also be formed of an inorganic material like the buffer layer 141, the gate insulating layer 142, the first interlayer insulating layer 143, the second interlayer insulating layer 144, and the passivation layer 145 may be easily damaged, such as being easily cracked, while the display device 100 is stretched. Accordingly, the gate insulating layer 142, the first interlayer insulating layer 143, the second interlayer insulating layer 144, and the passivation layer 145 may not be formed in areas between the plurality of first plate patterns 121 and may be patterned in the shapes of the plurality of first plate patterns 121 and formed only on the upper portions of the plurality of first plate patterns 121.

The planarization layer 146 is formed on the passivation layer 145. The planarization layer 146 planarizes upper portions of the switching transistor 150 and the driving transistor 160. The planarization layer 146 may be formed as a single layer or a plurality of layers and may be formed of an organic material. Thus, the planarization layer 146 may also be referred to as an organic insulating layer. For example, the planarization layer 146 may be formed of an acrylic-based organic material, but is not limited thereto.

Referring to FIG. 3, the planarization layer 146 may be disposed on the plurality of first plate patterns 121 to cover upper surfaces and side surfaces of the buffer layer 141, the gate insulating layer 142, the first interlayer insulating layer 143, the second interlayer insulating layer 144, and the passivation layer 145. The planarization layer 146 surrounds the buffer layer 141, the gate insulating layer 142, the first interlayer insulating layer 143, the second interlayer insulating layer 144, and the passivation layer 145 together with the plurality of first plate patterns 121. Specifically, the planarization layer 146 may be disposed to cover an upper surface and a side surface of the passivation layer 145, a side surface of the first interlayer insulating layer 143, a side surface of the second interlayer insulating layer 144, a side surface of the gate insulating layer 142, a side surface of the buffer layer 141 and a part of upper surfaces of the plurality of first plate patterns 121.

Referring to FIG. 3, an incline angle of the side surface of the planarization layer 146 may be less than those of the side surfaces of the buffer layer 141, the gate insulating layer 142, the first interlayer insulating layer 143, the second interlayer insulating layer 144 and the passivation layer 145. For example, the side surface of the planarization layer 146 may have a gentle incline than the side surface of the passivation layer 145, the side surface of the first interlayer insulating layer 143, the side surface of the second interlayer insulating layer 144, the side surface of the gate insulating layer 142 and the side surface of the buffer layer 141. Accordingly, the connection lines 180 in contact with the side surfaces of the planarization layer 146 are disposed to have a gentle incline. Therefore, when the display device 100 is stretched, stress generated in the connection lines 180 may be reduced. Thus, the planarization layer 146 may compensate for steps between the side surfaces of the buffer layer 141, the gate insulating layer 142, the first interlayer insulating layer 143, the second interlayer insulating layer 144, and the passivation layer 145.

In addition, since the side surface of the planarization layer 146 has a relatively gentle incline, cracking of the connection lines 180 or separation of the connection lines 180 from the side surfaces of the planarization layer 146 may be suppressed. Therefore, the planarization layer 146 may have an increase adhesive strength with the connection lines 180 disposed on the side surfaces of the planarization layer 146.

Referring to FIGS. 2 to 4, the plurality of connection lines 180 refer to lines that electrically connect the pads disposed on the plurality of first plate patterns 121. The plurality of connection lines 180 are disposed on the plurality of first line patterns 122. The plurality of connection lines 180 may also extend on the plurality of first plate patterns 121 to be electrically connected to the pads such as the gate pads GP, the data pad DP, and the power pad VD on the plurality of first plate patterns 121. The plurality of first line patterns 121 are not disposed in areas where the plurality of connection lines 180 are not disposed among the areas between the plurality of first plate patterns 121, Accordingly, the plurality of first line patterns 122 and the plurality of connection lines 180 may be defined as line units.

The plurality of connection lines 180 include the first connection lines 181 and the second connection lines 182. The first connection lines 181 and the second connection lines 182 are disposed between the plurality of first plate patterns 121. Specifically, the first connection lines 181 refer to lines extending in the first direction X between the plurality of first plate patterns 121 among the connection lines 180. The second connection lines 182 refer to lines extending in the second direction Y between the plurality of first plate patterns 121 among the connection lines 180.

The plurality of connection lines 180 may be formed of a metallic material such as copper (Cu), aluminum (Al), titanium (Ti) or molybdenum (Mo), or the plurality of connection lines 180 may have a laminated structure of metallic materials such as copper/molybdenum-titanium (Cu/MoTi), titanium/aluminum/titanium (Ti/AI/Ti), or the like, but are not limited thereto.

In a general display device, various lines such as a plurality of gate lines and a plurality of data lines are extended in linear shapes and are disposed between a plurality of sub-pixels, and the plurality of sub-pixels are connected to a single signal line. Therefore, in the general display device, various lines such as a gate line, a data line, a high potential voltage line and a reference voltage line are continuously extended on a substrate from one side to the other side of the display device.

Unlike this, in the display device 100 according to an exemplary embodiment of the present disclosure, various lines such as a gate line, a data line, a high potential voltage line, a reference voltage line, an initialization voltage line and the like formed in linear shapes, which can be considered to be used in a general display device, are disposed only on the plurality of first plate patterns 121 and the plurality of second plate patterns 123. That is, in the display device 100 according to an exemplary embodiment of the present disclosure, lines formed in linear shapes are disposed only on the plurality of first plate patterns 121 and the plurality of second plate patterns 123.

In the display device 100 according to an exemplary embodiment of the present disclosure, the pads on two first plate patterns 121 adjacent to each other may be connected by the connection lines 180. Accordingly, the connection lines 180 electrically connect the gate pads GP or the data pads DP on the two adjacent first plate patterns 121. Therefore, the display device 100 according to an exemplary embodiment of the present disclosure may include the plurality of connection lines 180 to electrically connect various lines, such as a gate line, a data line, a high potential voltage line and a reference voltage line, between the plurality of first plate patterns 121. For example, gate lines may be disposed on the plurality of first plate patterns 121 disposed adjacent to each other in the first direction X. The gate pads GP may be disposed on both ends of the gate lines. In this case, a plurality of the gate pads GP on the plurality of first plate patterns 121 disposed adjacent to each other in the first direction X may be connected to each other by the first connection lines 181 serving as gate lines. Therefore, the gate lines disposed on the plurality of first plate patterns 121 and the first connection lines 181 disposed on the first line patterns 122 may serve as single gate lines. Further, lines, such as an emission signal line, a low potential voltage line and a high potential voltage line which are extended in the first direction X among all of various lines that may be included in the display device 100, may also be electrically connected by the first connection lines 181 as described above.

Referring to FIGS. 2 and 4, some first connection lines 181 among the plurality of first connection lines 181 may connect the gate pads GP on two first plate patterns 121 that are disposed side by side among the gate pads GP on the plurality of first plate patterns 121 disposed adjacent to each other in the first direction X. The gate pads GP on the plurality of first plate patterns 121 disposed in the first direction X may be connected by the first connection lines 181 functioning as the gate lines and a single gate voltage may be transferred to the gate pads GP. However, the plurality of first connection lines 181 may function as emission signal lines, high potential voltage lines, or low potential voltage lines, in addition to the gate lines, but are not limited thereto.

Referring to FIGS. 2 and 3, some second connection lines 182 among the plurality of second connection lines 182 may connect the data pads DP on two first plate patterns 121 that are disposed side by side among the data pads DP on the plurality of first plate patterns 121 disposed adjacent to each other in the second direction Y. Internal lines on the plurality of first plate patterns 121 disposed in the second direction Y may be connected by the plurality of second connection lines 182 serving as the data lines, and a single data voltage may be transferred thereto. However, the plurality of second connection lines 182 may function as data lines, high potential voltage lines, low potential voltage lines, or reference voltage lines, but are not limited thereto.

Referring to FIG. 4, the first connection line 181 may be disposed to be in contact with an upper surface and side surfaces of the planarization layer 146 disposed on the first plate pattern 121. The first connection line 181 may be disposed on an upper surface of the first line pattern 122 and both ends thereof may be formed to extend above the first plate pattern 121. In addition, the second connection line 182 may be disposed to be in contact with the upper surface and the side surface of the planarization layer 146 disposed on the first plate pattern 121. In addition, the second connection line 182 may also be disposed on an upper surface of the first line pattern 122 and both ends thereof may be formed to extend above the first plate pattern 121.

Referring to FIG. 5, since it is unnecessary to dispose a rigid pattern in an area where the first connection line 181 and the second connection line 182 are not disposed, the plurality of first line patterns 122 are not disposed therein.

Referring to FIG. 3 again, banks 147 are formed on a connection pad CNT, the connection lines 180 and the planarization layer 146. The bank 147 is a component to divide the sub-pixels SPX adjacent to each other. The bank 147 is disposed to cover at least a part of the connection pad CNT, the connection lines 181 and 182 and the planarization layer 146. The bank 147 may be formed of an insulating material. Further, the bank 147 may contain a black material to thereby hide lines which are visible through the active area AA. The bank 147 may be formed of, for example, a carbon-based mixture, and may specifically include carbon black. However, it is not limited thereto, and the bank 147 may be formed of a transparent insulating material. Also, although a height of the bank 147 is illustrated as being lower than a height of the LED 170 in the drawing, the height of the bank 147 may be the same as the height of the LED 170, but is not limited thereto.

The LED 170 is disposed on the connection pad CNT and the first connection line 181. The LED 170 includes an n-type layer 171, an active layer 172, a p-type layer 173, an n-electrode 175 and a p-electrode 174. The LED 170 of the display device 100 according to an exemplary embodiment of the present disclosure has a flip-chip structure in which the n-electrode 175 and the p-electrode 174 are formed on one surface thereof.

The n-type layer 171 may be formed by implanting n-type impurities into gallium nitride (GaN) having excellent crystallinity. The n-type layer 171 may be disposed on a separate base substrate which is formed of a light emitting material. For example, the n-type impurity may be silicon (Si), germanium, or tin (Sn), but is not limited thereto.

The active layer 172 is disposed on the n-type layer 171. The active layer 172 is a light emitting layer that emits light from the LED 170 and may have a single or multi-quantum well (MQW) structure. The active layer 172 may be formed of, for example, a nitride semiconductor such as indium gallium nitride (InGaN) or gallium nitride (GaN), but is not limited thereto.

The p-type layer 173 is disposed on the active layer 172. The p-type layer 173 may be formed by implanting p-type impurities into gallium nitride (GaN). For example, the p-type impurity may be magnesium, zinc (Zn), or beryllium (Be), but is not limited thereto.

As described above, the LED 170 according to an exemplary embodiment of the present disclosure is manufactured by sequentially laminating the n-type layer 171, the active layer 172, and the p-type layer 173, and then, etching a predetermined area of the layers to thereby form the n-electrode 175 and the p-electrode 174. In this case, the predetermined area is a space to separate the n-electrode 175 and the p-electrode 174 from each other and is etched to expose a part of the n-type layer 171. In other words, a surface of the LED 170 on which the n-electrode 175 and the p-electrode 174 are to be disposed may not be flat and may have different levels of height.

In this manner, the n-electrode 175 is disposed in the etched area, and the n-electrode 175 may be formed of a conductive material. In addition, the p-electrode 174 is disposed in a non-etched area, and the p-electrode 174 may also be formed of a conductive material. For example, the n-electrode 175 is disposed on the n-type layer 171 exposed by an etching process, and the p-electrode 174 is disposed on the p-type layer 173. The p-electrode 174 may be formed of the same material as the n-electrode 175.

A conductive adhesive layer AD is disposed on upper surfaces of the connection pad CNT and the first connection line 181 and between the connection pad CNT and the first connection line 181. Thus, the LED 170 may be bonded onto the connection pad CNT and the first connection line 181. In this case, the n-electrode 175 may be disposed on the first connection line 181 and the p-electrode 174 may be disposed on the connection pad CNT.

The conductive adhesive layer AD may be a conductive adhesive layer formed by dispersing conductive balls in an insulating base member. Thus, when heat or pressure is applied to the conductive adhesive layer AD, the conductive balls are electrically connected to have conductive properties in a portion of the conductive adhesive layer AD to which heat or pressure is applied and have insulating properties in a portion of the conductive adhesive layer AD to which no heat or pressure is applied. For example, the n-electrode 175 is electrically connected to the first connection line 181 through the conductive adhesive layer AD, and the p-electrode 174 is electrically connected to the connection pad CNT through the conductive adhesive layer AD. After applying the conductive adhesive layer AD to the upper surface of the first connection line 181 and the connection pad CNT by an inkjet method or the like, the LED 170 may be transferred onto the conductive adhesive layer AD. Then, the LED 170 may be pressed and heated to thereby electrically connect the connection pad CNT with the p-electrode 174, and the first connection line 181 with the n-electrode 175. Accordingly, other portions of the conductive adhesive layer AD excluding a portion of the conductive adhesive layer AD disposed between the n-electrode 175 and the first connection line 181 and a portion of the conductive adhesive layer AD disposed between the p-electrode 174 and the connection pad CNT may not be pressed and have insulating properties. Meanwhile, the conductive adhesive layer AD may be entirely disposed on the connection pad CNT and the first connection line 181 as illustrated in the drawing, but the conductive adhesive layer AD may be disposed on each of the connection pad CNT and the first connection line 181 in a separate form. However, the present disclosure is not limited thereto.

The connection pad CNT may be electrically connected to the driving drain electrode 164 of the driving transistor 160 and receive a driving voltage for driving the LED 170 from the driving transistor 160. Although FIG. 3 illustrates that the connection pad CNT and the driving drain electrode 164 are indirectly connected to each other without being in directly contact, the present disclosure is not limited thereto. The connection pad CNT and the driving drain electrode 164 may be in direct contact. In addition, a low potential driving voltage for driving the LED 170 is applied to the first connection line 181. Accordingly, when the display device 100 is turned on, different voltage levels that are applied to the connection pad CNT and the first connection line 181 are respectively transferred to the n-electrode 175 and the p-electrode 174, so that the LED 170 emits light.

Next, the second adhesive layer OCA2 is disposed on the LED 170 and the lower substrate 111. The second adhesive layer OCA2 is a member for bonding the upper substrate 112 and the lower substrate 111 on which the filling layer 190 and the LED 170 are formed, and may be a transparent adhesive film such as optically clear adhesive (OCA). At least a portion of the second adhesive layer OCA2 may contact a component disposed on the first plate pattern 121, for example, the LED 170.

The upper substrate 112 is disposed on the second adhesive layer OCA2. The upper substrate 112 is a substrate supporting various components disposed under the upper substrate 112. For example, the upper substrate 112 may be formed by coating a material constituting the upper substrate 112 on the lower substrate 111 and the first plate pattern 121 and then curing the material.

The upper substrate 112 may be formed of the same material as the lower substrate 111. For example, the upper substrate 112 may be formed of silicone rubber such as polydimethylsiloxane (PDMS) or an elastomer such as polyurethane (PU) or polytetrafluoroethylene (PTFE). Thus, the upper substrate 112 may have flexibility. However, the materials of the upper substrate 112 are not limited thereto.

Meanwhile, although not illustrated in FIG. 3, a polarizing layer may also be disposed on the upper substrate 112. The polarizing layer may function to polarize light incident from the outside of the display device 100 and reduce reflection of external light. Further, instead of the polarizing layer, other optical films or the like may be disposed on the upper substrate 112.

The filling layer 190 is disposed between the first adhesive layer OCA1 and the second adhesive layer OCA2. The filling layer 190 may fill all of empty spaces between the first adhesive layer OCA1 and the second adhesive layer OCA2. For example, the filling layer 190 may fill all of components between the first adhesive layer OCA1 and the second adhesive layer OCA2 as well as grooves 122G in lower portions of the plurality of first line patterns 122, that is, empty spaces between the plurality of first line patterns 122 and the first adhesive layer OCA1. In this case, the filling layer 190 filling the grooves 122G can prevent the plurality of first line patterns 122 from being attached to the first adhesive layer OCA1, and the plurality of connection lines 180 and the plurality of first line patterns 122 are surrounded by the filling layer 190 and may be in a floating state.

Specifically, the filling layer 190 include a first filling layer 191 and a second filling layer 192. The first filling layer 191 and the second filling layer 192 are disposed to fill spaces between the first adhesive layer OCA1 and the second adhesive layer OCA2 and may be integrally formed.

The first filling layer 191 is disposed to fill spaces between the plurality of connection lines 180 and the second adhesive layer OCA2. The first filling layer 191 may cover the plurality of first line patterns 122 and the plurality of connection lines 180. For example, the first filling layer 191 may cover all of upper, left, and right portions of the plurality of connection lines 180 and the plurality of first line patterns 122. Also, the first filling layer 191 may be disposed to cover components disposed on the plurality of first plate patterns 121. For example, the first filling layer 191 is disposed to fill spaces on the plurality of first plate patterns 121 and may cover the LEDs 170, the banks 147, the connection pad CNT, the planarization layer 146, and the like, disposed on the first plate patterns 121.

The second filling layer 192 is disposed to fill spaces between the plurality of first line patterns 122 and the first adhesive layer OCA1. The second filling layer 192 may be disposed to fill the grooves 122G in the lower portions of the plurality of first line patterns 122. Accordingly, as described above, the plurality of first line patterns 122 and the plurality of connection lines 180 may be separated from the first adhesive layer OCA1 by the second filling layer 192 filling the grooves 122G. In addition, the second filling layer 192 may be disposed to surround the plurality of first line patterns 122 and the plurality of connection lines 180 together with the first filling layer 191. Therefore, the plurality of first line patterns 122 and the plurality of connection lines 180 may float by being surrounded by the first filling layer 191 and the second filling layer 192 that are formed of a liquid material.

The filling layer 190 may be formed of a non-conductive liquid material to prevent corrosion or electrical failure of conductive materials directly in contact with the filling layer 190, for example, a plurality of the LEDs 170 or the plurality of connection lines 180. The filling layer 190 may be formed of a liquid material having a high specific resistance in order to prevent electrical interference of the plurality of connection lines 180, the plurality of LEDs 170, or the connection pad CNT. Also, the filling layer 190 may be formed of a liquid material in which cured polymer material layers, for example, the first adhesive layer OCA1 and the second adhesive layer OCA2 are not dissolved. Also, the filling layer 190 may be formed of a material having low viscosity so that the plurality of connection lines 180 and the plurality of first line patterns 122 can be easily deformed.

For example, the filling layer 190 may be formed of a silicone polymer such as ecoflex or polydimethylsiloxane (PDMS) that does not contain silicone oil or a curing agent. The filling layer 190 may be formed of a material having a specific resistance of about 3 × 10¹⁴ Ohm·cm or higher and a viscosity of about 5 Pa s or less, but the present disclosure is not limited thereto.

In the display device 100 according to an exemplary embodiment of the present disclosure, the filling layer 190 formed of a liquid material fills the spaces between the first adhesive layer OCA1 and the second adhesive layer OCA2, so that deformation characteristics of the plurality of first line patterns 122 and the plurality of connection lines 180 may be improved, and stretchability of the display device 100 may be improved. When the display device 100 is stretched, the plurality of first line patterns 122 and the plurality of connection lines 180 may be stretched. At this time, if the plurality of first line patterns 122 are attached to the first adhesive layer OCA1, stretchability of the plurality of first line patterns 122 and the plurality of connection lines 180 may be lowered by the first adhesive layer OCA1. Accordingly, by forming the first filling layer 191 covering the plurality of first line patterns 122 and the plurality of connection lines 180, it is possible to minimize a phenomenon in which the plurality of first line patterns 122 and the plurality of connection lines 180 are in contact and interfered with by the second adhesive layer OCA2 or other components having rigidity. In addition, the grooves 122G are formed in lower portions of the plurality of first line patterns 122 to separate the first adhesive layer OCA1 from the plurality of first line patterns 122. The grooves 122G are filled with the second filling layer 192 that is a liquid material, so that a phenomenon in which stretchability is lowered as the plurality of first line patterns 122 are adhered to the first adhesive layer OCA1 may be minimized. Also, the first filling layer 191 and the second filling layer 192 are disposed to surround all of upper, lower, left, and right portions of the plurality of first line patterns 122 and the plurality of connection lines 180, so that the plurality of first line patterns 122 and the plurality of connection lines 180 may float within the filling layer 190 that is formed of a liquid material. Accordingly, since the plurality of first line patterns 122 and the plurality of connection lines 180 floating within the filling layer 190 are not interfered with by other components during stretching, stress may be reduced and stretchability may be maximized.

The filling layer 190 may be formed by an application method or an injection method, and a method of manufacturing the display device 100 according to an exemplary embodiment of the present disclosure will be described in detail with reference to FIG. 6A to FIG. 7.

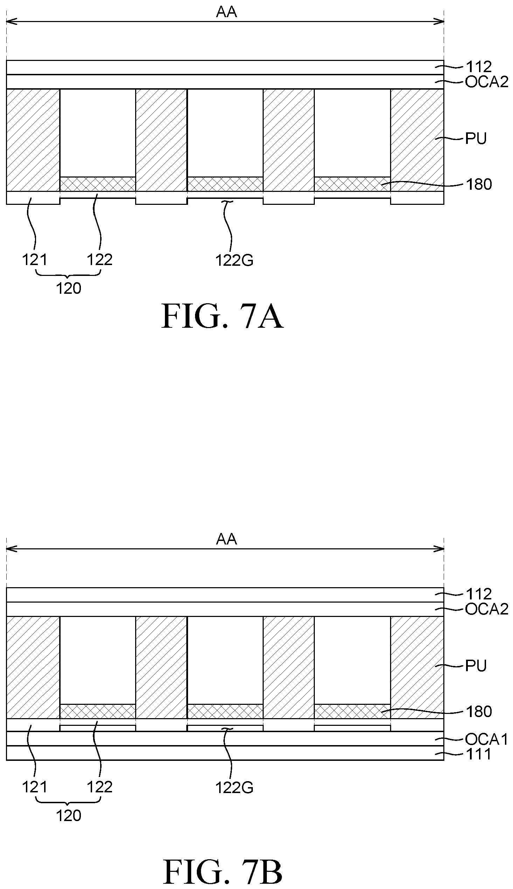

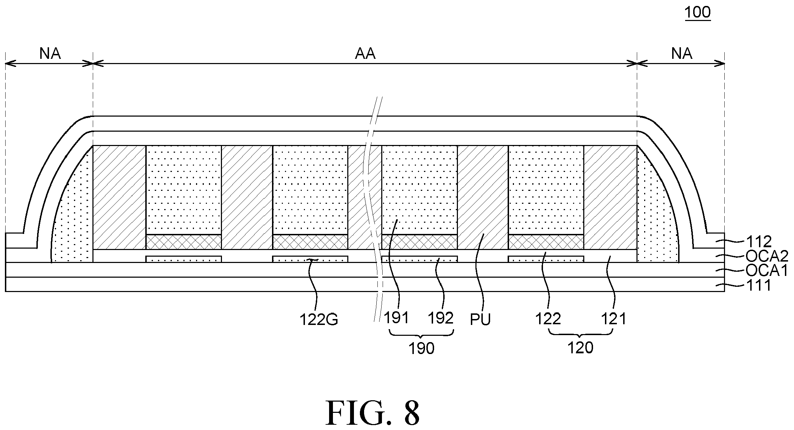

FIGS. 6A to 6D are process views for explaining a method of manufacturing the display device according to an exemplary embodiment of the present disclosure. FIGS. 7A to 7C are process views for explaining a method of manufacturing the display device according to an exemplary embodiment of the present disclosure. FIG. 8 is a schematic cross-sectional view of the display device according to an exemplary embodiment of the present disclosure. FIGS. 6A to 6D are process views in the case of forming the filling layer 190 by an application method, and FIGS. 7A to 7C are process views in the case of forming the filling layer 190 by an injection method. For convenience of description, only a portion of the display device 100 corresponding to the active area AA is illustrated in FIGS. 6A to 7C, and an overall cross-sectional view of the display device 100 is illustrated in FIG. 8. In FIGS. 6A to 8, the plurality of first plate patterns 121 and the components above the plurality of first plate patterns 121 are defined as pixel units PU, and the plurality of first line patterns 122 and the plurality of connection lines 180 will be defined and described as line units LU.

First, the filling layer 190 formed of a liquid material may be formed by either an application method or an injection method. After the liquid material constituting the filling layer 190 is applied to an entire surface of the display device 100, the filling layer 190 may be sealed. In addition, in a state in which the display device 100 is partially sealed, the liquid material constituting the filling layer 190 may be injected into the display device 100 through a partial area thereof that is not sealed.

The present disclosure is not limited to the embodiments using either an application or an injection method, and other suitable methods may be utilized. For the purpose of explanation, an application method will be described in conjunction with FIGS. 6A to 6D and an injection method will be described in conjunction with FIGS. 7A to 7C.

Referring to FIG. 6A in relation to the application method, the pattern layer 120 including the plurality of first plate patterns 121 and the plurality of first line patterns 122 is formed on a temporary substrate GLS. Next, the pixel units PU that include the sub-pixels SPX are formed on the pattern layer 120. The pixel units PU include various circuit elements for driving the display device. Since the pixel units PU include various circuit elements, in some embodiments, it may also refer to as pixel circuits PU (or a pixel circuit layer PU). The pixel units PU include sub-pixels SPX and some example circuit elements included in the sub-pixels SPX include the driving transistors 160, the switching transistors 150, and the LEDs 170, and the line units LU including the plurality of connection lines 180. Finally, the second adhesive layer OCA2 and the upper substrate 112 are formed on the pixel units PU and the pattern layer 120.

Referring to FIG. 6B, the temporary substrate GLS is separated from the pattern layer 120, and the grooves 122G to be filled with the filling layer 190 are formed in a lower portion of the pattern layer 120. The grooves 122G are formed in the lower portion of the pattern layer 120 overlapping the line units LU so that empty spaces are formed between the first adhesive layer OCA1 to be formed later and the plurality of first line patterns 122. For example, portions of lower sides of the plurality of first line patterns 122 may be patterned by irradiating a laser to the lower portions of the plurality of first line patterns 122, or portions of the lower sides of the plurality of first line patterns 122 may be patterned by a photolithography process.

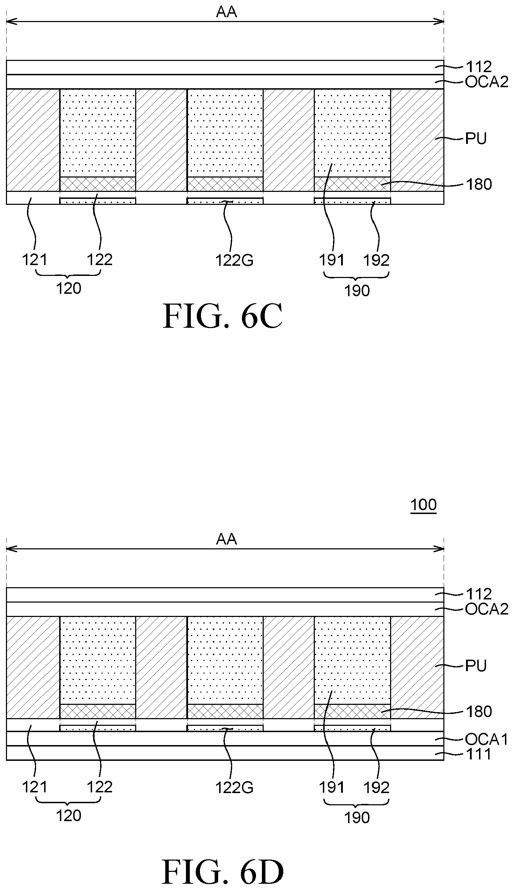

Referring to FIG. 6C, a material constituting the filling layer 190 is applied onto the entire surface of the pixel unit PU and the line unit LU. In this case, after placing the upper substrate 112 downward, the first filling layer 191 may fill the empty spaces between the second adhesive layer OCA2 and the line units LU, and the second filling layer 192 may fill the grooves 122G in the lower portion of the pattern layer 120. Accordingly, the filling layer 190 may be formed by applying a material constituting the filling layer 190 to fill all of empty spaces between the second adhesive layer OCA2 and a lower surface of the pattern layer 120.

Next, referring to FIGS. 6D and 8 together, a manufacturing process of the display device 100 is completed by forming the first adhesive layer OCA1 covering the pattern layer 120 filled with the filling layer 190 and the lower substrate 111. The first adhesive layer OCA1 may be formed to cover the pattern layer 120 to which the second filling layer 192 of the filling layer 190 is applied. Accordingly, the display device 100 may be sealed such that the filling layer 190 goes outside the display device 100. For example, as illustrated in FIG. 8, the first adhesive layer OCA1 and the second adhesive layer OCA2 are adhered to each other in an outside of the pattern layer 120, that is, in the non-active area NA, and may seal the active area AA filled with the filling layer 190.

Next, referring to FIG. 7A in relation to the injection method, the pattern layer 120, the pixel units PU, the line units LU, the second adhesive layer OCA2, and the upper substrate 112 are formed on the temporary substrate GLS, and the temporary substrate GLS is separated therefrom. In addition, the lower portions of the plurality of first line patterns 122 of the pattern layer 120 exposed from the temporary substrate GLS are partially patterned to form the grooves 122G injected with the filling layer 190. That is, the process of forming the grooves 122G in the lower portions of the plurality of first line patterns 122 is substantially identical to the application method. The temporary substrate GLS can also be referred to as a sacrificial substrate.

Next, referring to FIG. 7B, the first adhesive layer OCA1 and the lower substrate 111 are formed under the pattern layer 120. At this time, the first adhesive layer OCA1 is formed, while at least portions of the first adhesive layer OCA1 and the second adhesive layer OCA2 may be separated in the non-active area NA to form injection holes in which the filling layer 190 can be injected.

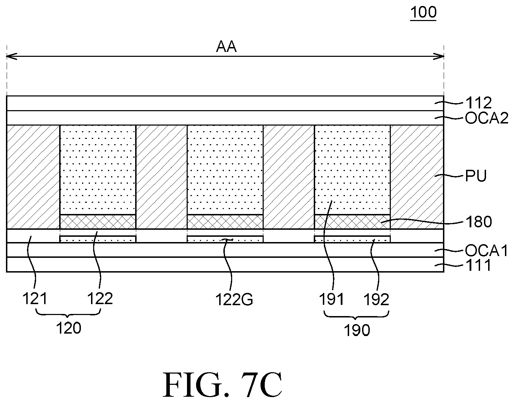

Next, referring to FIG. 7C, a material constituting the filling layer 190 may be injected into the empty spaces between the first adhesive layer OCA1 and the second adhesive layer OCA2 through the injection holes. The filling layer 190 is filed in the active area AA through the injection holes and may fill empty spaces between the pixel units PU and empty spaces between the first adhesive layer OCA1 and the pattern layer 120. For example, the first filling layer 191 may fill an empty space between the pixel unit PU and the pattern layer 120, and the second adhesive layer OCA2, and the second filling layer 192 may fill the groove 122G in the lower portion of the pattern layer 120.

Finally, referring to FIG. 8, when the injection of the filling layer 190 is completed, the first adhesive layer OCA1 and the second adhesive layer OCA2 may be entirely bonded in the non-active area NA to seal the active area AA.

Meanwhile, although not illustrated in the drawings, a plurality of dams may be formed in a part of the non-active area NA between the active area AA and a portion where the first adhesive layer OCA1 and the second adhesive layer OCA2 are attached to each other. The plurality of dams may control the filling layer 190 of the active area AA not to spread toward the non-active area NA.

In the display device 100 according to an exemplary embodiment of the present disclosure, the empty spaces of the active area AA are filled with the filling layer 190 which is a liquid material, so that the plurality of first line patterns 122 and the plurality of connection lines 180 can be more easily stretched. At this time, the filling layer 190 may be formed by an application method of applying a liquid material to an entire surface of the second adhesive layer OCA2 on which the pattern layer 120 and the pixel units PU are formed, or a filling method of, after partially sealing the active area AA, filling an interior of the active area AA with a liquid material through an injection hole that is not sealed. In addition, the active area AA may be sealed by attaching the first adhesive layer OCA1 and the second adhesive layer OCA2 in the non-active area NA so that the filling layer 190 is disposed inside the active area AA. Therefore, the filling layer 190 fills the interior of the display device 100 in various manners, so that the plurality of first line patterns 122 and the plurality of connection lines 180 are configured to float without being adhered to the first adhesive layer OCA1. Accordingly, stretchability of the display device 100 can be improved.

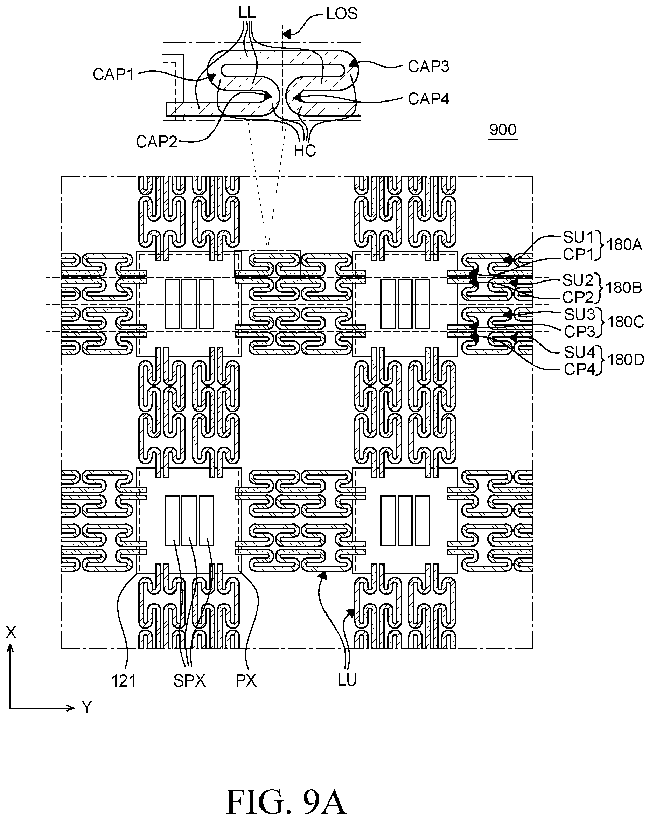

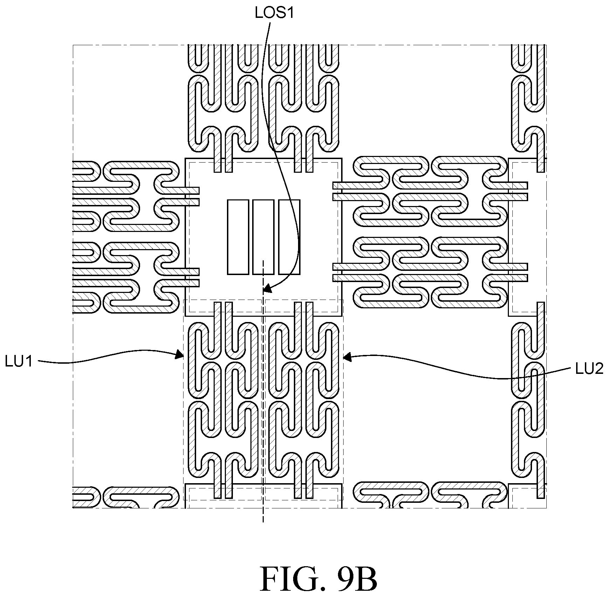

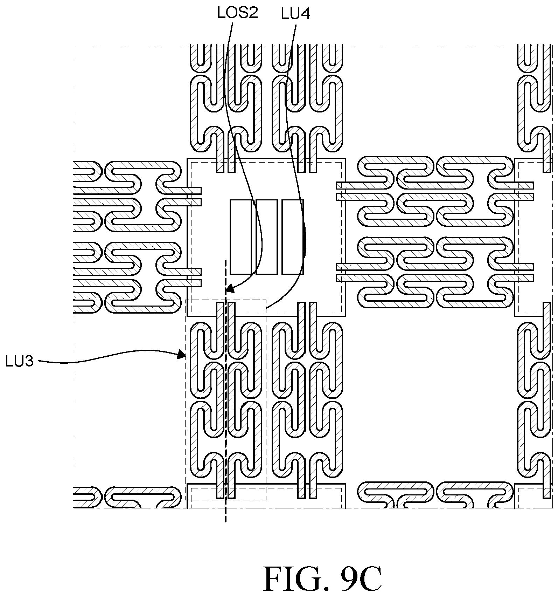

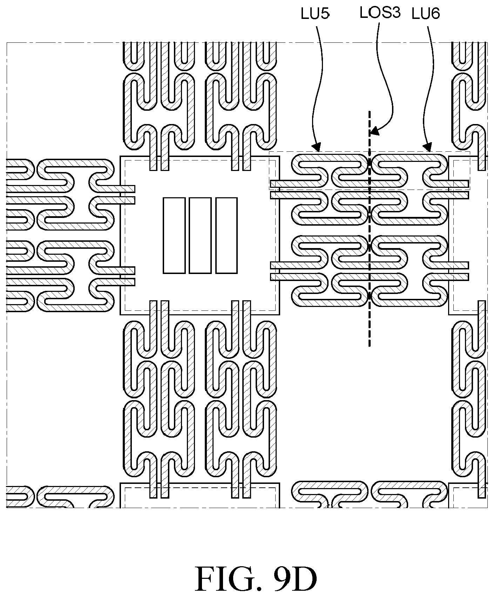

FIGS. 9 to 12 are enlarged plan views of display devices according to various exemplary embodiments of the present disclosure. Other configurations of each of display devices 900, 1000, 1100, and 1200 of FIGS. 9 to 12 are substantially identical to those of the display device 100 of FIGS. 1 to 8 except for differences in terms of shapes of the plurality of first line patterns 122 and the plurality of connection lines 180. Thus, redundant descriptions will be omitted.

The filling layer 190 which is a liquid material, may be formed in the active area AA so that the plurality of first line patterns 122 and the plurality of connection lines 180 can be more easily deformed. The plurality of first line patterns 122 and the plurality of connection lines 180 float in the filling layer 190 which is a liquid material, and may be stretched without being interfered with by other components when the display device is stretched.

In this case, by forming the filling layer 190, it is possible to facilitate deformation of a plurality of the line units LU including the plurality of first line patterns 122 and the plurality of connection lines 180. At the same time, by deforming shapes of the plurality of line units LU together, it is possible to reduce stress applied to the line units LU and increase a stretching rate, thereby improving stretching reliability.

For example, referring to FIG. 9A, in the display device 900 according to another exemplary embodiment of the present disclosure, the line units LU including the plurality of first line patterns 122 and the plurality of connection lines 180 are configured with a plurality of semicircular portions HC and a plurality of linear portions LL, so that stress of the line units LU may be reduced and a stretching rate may be increased. In particular, convex arc portions CAP1, CAP2, CAP3, CAP4 of the plurality of semicircular portions HC may be disposed in the same direction as a stretching direction of the line unit LU. Meanwhile, in some embodiments, the plurality of linear portions LL and the plurality of semicircular portions HC may be defined as a stretchable unit and the rest of the connection lines 180 except for the stretchable unit may be defined as a connection portion. The connection portion may be a part of a connection lines 180 connecting the plate pattern 121 and the stretchable unit.

For example, each of the plurality of line units LU may include a plurality of semicircular portions HC and a plurality of linear portions LL that are alternately disposed. The convex arc portions CAP1, CAP2, CAP3, CAP4 of the plurality of semicircular portions HC may disposed along the stretching direction. In the line unit LU extending in the first direction X, the convex arc portion of each of the plurality of semicircular portions HC may be disposed in the first direction X. In the line unit LU extending in the second direction Y, the convex arc portion of each of the plurality of semicircular portions HC may be disposed in the second direction Y. Also, the plurality of linear portions LL may connect the plurality of semicircular portions HC to each other. For instance, a first convex arc portion CAP1 is between adjacent linear portions LL, a second convex arc portion CAP2 is between adjacent linear portions LL, a third convex arc portion CAP3 is between adjacent linear portions LL, and a fourth convex arc portion CAP4 is between adjacent linear portions LL. Further, according to one embodiment, the first convex arc portion CAP1 and the third convex arc portion CAP3 may be symmetrical with respect to a line of symmetry LOS and the second convex arc portion CAP2 and the fourth convex arc portion CAP4 may be symmetrical with respect to the line of symmetry LOS.

For example, in one of the line units LU extending in the first direction X, the linear portions LL extending in the first direction X and the semicircular portions HC having convex arc portions facing in a right direction or a left direction may be alternately disposed. That is, the line unit LU extending in the first direction X may have a structure in which the linear portion LL is disposed between the semicircular portion HC having a convex arc portion facing in the left direction and the semicircular portion HC having a convex arc portion facing in the right direction.

For example, in one of the line units LU extending in the second direction Y, the linear portions LL extending in the second direction Y and the semicircular portions HC having convex arc portions facing in an upper direction or a lower direction may be alternately disposed.

The line units LU can be arranged in various symmetrical manners in order to reduce the stress applied to the line units LU and also increase the stretching rate. For example, according to one embodiment shown in FIG. 9B, a first line unit LU1 is symmetrical to a second line unit LU2 with respect to a first line of symmetry LOS1. According to FIG. 9C, a third line unit LU3 is symmetrical to a fourth line unit LU4 with respect to a second line of symmetry LOS2. Further, according to FIG. 9D, a fifth line unit LU5 is symmetrical to a sixth line unit LU6 with respect to a third line of symmetry LOS3.

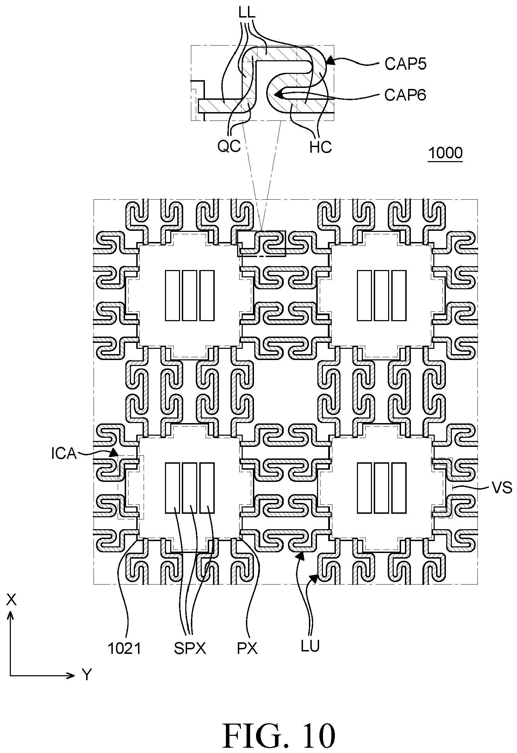

Next, referring to FIG. 10, in the display device 1000 according to still another exemplary embodiment of the present disclosure, the line units LU including the plurality of first line patterns 122 and the plurality of connection lines 180 are configured with a plurality of semicircular portions HC, a plurality of quadrant portions QC, and a plurality of linear portions LL, so that stress of the line units LU may be reduced and a stretching rate may be increased. Also, a portion of the line unit LU adjacent to a first plate pattern 1021 is configured with the quadrant portion QC and the linear portion LL, so that an area of the first plate pattern 1021 on which the pixel PX is disposed can also be increased.

For example, in each of the plurality of line units LU, the linear portions LL may be disposed between the semicircular portion HC and the semicircular portion HC, between the semicircular portion HC and the quadrant portion QC, and between the quadrant portion QC and the quadrant portion QC. Also, some semicircular portions HC among the plurality of semicircular portions HC may be directly connected without the linear portion LL therebetween. For instance, as shown in FIG. 10, a fifth convex arc portion CAP5 and a sixth convex arc portion CAP6 may be directly connected to each other without having a linear portion of a quadrant portion QC in between them. At this time, since ends of each of the quadrant portions QC face in different directions, the linear portions LL disposed on both sides of the quadrant portions QC may extend in different directions. For example, the linear portion LL connected to one side of the quadrant portion QC may extend in the first direction X, and the linear portion LL connected to the other side of the quadrant portion QC may extend in the second direction Y.

In summary, one end of one quadrant portion QC may be connected to any one of another quadrant portion QC, the linear portion LL, and the semicircular portion HC. One end of the linear portion LL may be connected to either the quadrant portion QC or the semicircular portion HC. One end of the semicircular portion HC may be connected to either the linear portion LL or the quadrant portion QC.

For example, one line unit LU among the line units LU extending in the first direction X may include the linear portion LL extending in the first direction X from an edge of the first plate pattern 1021, the quadrant portion QC extending from the linear portion LL disposed in the first direction X and having a convex arc portion facing in a lower right diagonal direction or a lower left diagonal direction, the linear portion LL extending in the second direction Y from the quadrant portion QC, the quadrant portion QC extending from the linear portion LL disposed in the second direction Y and having a convex arc portion facing in an upper left diagonal direction or an upper right diagonal direction, and the semicircular portion HC extending from the linear portion L disposed in the first direction X and having a convex arc portion facing in the right direction or the left direction.

For example, one line unit LU among the line units LU extending in the second direction Y may include the linear portion LL extending in the second direction Y from an edge of the first plate pattern 1021, the quadrant portion QC extending from the linear portion LL disposed in the second direction Y and having a convex arc portion facing in the upper right diagonal direction or the upper left diagonal direction, the linear portion LL extending in the first direction X from the quadrant portion QC, and the semicircular portion HC having a convex arc portion in the second direction Y facing in the right direction or the left direction.

Meanwhile, when the quadrant portion QC is connected to the linear portion LL closest to the first plate pattern 1021 among the plurality of linear portions LL, a pair of linear portions LL with the quadrant portion QC interposed therebetween may form a vertical structure VS. Further, the area of the first plate pattern 1021 may be increased by extending the first plate pattern 1021 into an empty space formed through the vertical structure VS. That is, the first plate pattern 1021 may have an increased plate area ICA compared to the first plate pattern illustrated in FIG. 2 or FIG. 9A due to the space provided by the vertical structure VS. For example, among the four line units LU disposed between a pair of the first plate patterns 1021 adjacent to each other, two middle line units LU may have a symmetrical structure. In this case, the vertical structures VS formed at respective both ends of the two line units LU may face each other and form rectangular empty spaces, and the increased plate area ICA of the first plate patterns 1021 may extend into the empty spaces. As shown, there are four increased plate areas for each first plate pattern 1021. In one or more embodiments, the increased plate area ICA is continuous and contiguous to the first plate pattern 1021. Accordingly, by forming the vertical structures VS of the line units LU with a combination of the plurality of linear portions LL, the plurality of quadrant portions QC, and the plurality of semicircular portions HC, spaces into which the first plate patterns 1021 can be extended may be secured.

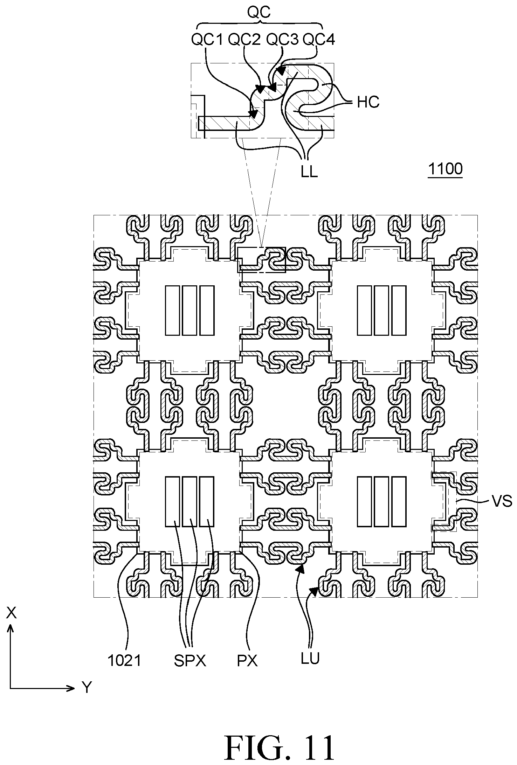

Next, referring to FIG. 11, in the display device 1100 according to still another exemplary embodiment of the present disclosure, the line units LU including the plurality of first line patterns 122 and the plurality of connection lines 180 are configured with a plurality of semicircular portions HC, a plurality of quadrant portions QC, and a plurality of linear portions LL, so that stress of the line units LU may be reduced and a stretching rate may be increased. Also, a portion of the line unit LU adjacent to the first plate pattern 1021 is configured with the quadrant portion QC and the linear portion LL, so that the area of the first plate pattern 1021 on which the pixel PX is disposed can also be increased.

For example, in each of the plurality of line units LU, the linear portion LL may be disposed between the semicircular portion HC and the quadrant portion QC. In addition, some semicircular portions HC among the plurality of semicircular portions HC may be connected to each other without the linear portion LL therebetween, and some quadrant portions QC among the plurality of quadrant portions QC may be connected to each other without the linear portion LL interposed therebetween. For instance, as shown in FIG. 11, a first quadrant portion QC1 is between a linear portion LL and a second quadrant portion QC2. The second quadrant portion QC2 is between the first quadrant portion QC1 and a third quadrant portion QC3. Similarly, the third quadrant portion QC3 is between the second quadrant portion QC2 and a fourth quadrant portion QC4. The fourth quadrant portion QC4 is between a semicircular portion HC and a third quadrant portion QC3. Here, the second quadrant portion QC 2 is directly connected to adjacent quadrant portions (e.g., QC1 and QC3) and the third quadrant portions QC3 is also directly connected to adjacent quadrant portions (e.g., QC2 and QC4).

In summary, one end of one quadrant portion QC may be connected to another quadrant portion QC or the linear portion LL. One end of the linear portion LL may be connected to either the quadrant portion QC or the semicircular portion HC. One end of the semicircular portion HC may be connected to either the linear portion LL or the semicircular portion HC.

For example, one line unit LU among the line units LU extending in the first direction X may include the linear portion LL extending in the first direction X from the edge of the first plate pattern 1021, the quadrant portion QC extending from the linear portion LL or another quadrant portion QC and having a convex arc portion facing in the lower right diagonal direction or the lower left diagonal direction, and the semicircular portion HC extending from the linear portion L or another semicircular portion HC and having a convex arc portion facing rightward or leftward.

For example, one line unit LU among the line units LU extending in the second direction Y may include the linear portion LL extending in the second direction Y from an edge of the first plate pattern 1021, the quadrant portion QC extending from the linear portion LL or another quadrant portion QC and having a convex arc portion facing in the upper right diagonal direction or the upper left diagonal direction, and the semicircular portion HC extending from the linear portion LL or another semicircular portion HC and having a convex arc portion facing in the right direction or the left direction.

Also, similar to the display device 1000 of FIG. 10, the display device 1100 of FIG. 11 may also have the vertical structures VS in which the first plate patterns 1021 can be extended by configuring the both ends of the line units LU adjacent to the first plate patterns 1021 with the linear portions LL and the quadrant portions QC. The vertical structures VS at the both ends of the two adjacent line units LU may face each other and form rectangular empty spaces, and the first plate patterns 1021 may be extended into the empty spaces, so that areas of first plate patterns 1021 can be increased.

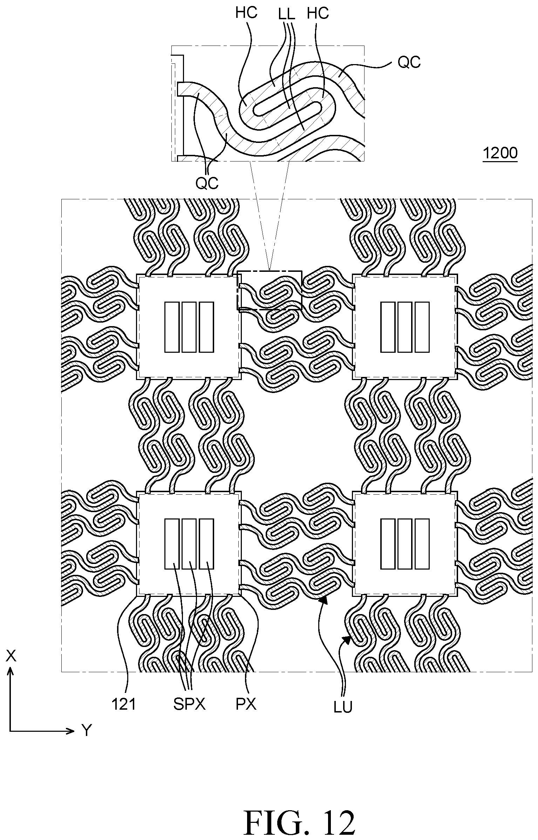

Next, referring to FIG. 12, in the display device 1200 according to still another exemplary embodiment of the present disclosure, the line units LU including the plurality of first line patterns 122 and the plurality of connection lines 180 are configured with a plurality of semicircular portions HC, a plurality of quadrant portions QC, and a plurality of linear portions LL, that are tilted in diagonal directions other than the first direction X and the second direction Y. Accordingly, stress of the line units LU may be reduced and a stretching rate may be increased. In addition, the stretching rate of the line units LU may be increased by differently configuring the radii of the plurality of semicircular portions HC and the plurality of quadrant portions QC.

For example, both ends of the plurality of semicircular portions HC and the plurality of quadrant portions QC may be disposed in different directions other than the first direction X and the second direction Y. Accordingly, the both ends of the plurality of semicircular portions HC may be disposed in diagonal directions, and convex arc portions of the plurality of semicircular portions HC may also be disposed in diagonal directions. In addition, both ends of the plurality of quadrant portions QC may be disposed in diagonal directions, and convex arc portions of the plurality of quadrant portions QC may face nearly in the second direction Y or the first direction X instead of the diagonal directions.

Also, the plurality of semicircular portions HC and the plurality of quadrant portions QC are configured to have different radii, so that the line unit LU can be easily stretched. For example, by forming a radius of the quadrant portion QC to be greater than a radius of the semicircular portion HC, an overall length of the line unit LU can be further increased while the stretching rate of the line unit LU can be increased. A shape of the unit LU can be designed more variously.

For example, one line unit LU among the line units LU extending in the first direction X may include the quadrant portion QC extending from the edge of the first plate pattern 121 and having a convex arc portion facing in the upper direction or the lower direction, the quadrant portion QC extending from another quadrant portion QC or the linear portion LL and having a convex arc portion facing in the lower direction or the upper direction, the linear portion LL extending from the quadrant portion QC or the semicircular portion HC in the upper right diagonal direction and the lower left diagonal direction, and the semicircular portion HC extending from the linear portion LL in the upper right diagonal direction or the lower left diagonal direction.

For example, one line unit LU among the line units LU extending in the second direction Y may include the quadrant portion QC extending from the edge of the first plate pattern 121 and having a convex arc portion facing in the left direction or in the right direction, the quadrant portion QC extending from another quadrant portion QC or the linear portion LL and having a convex arc portion facing in the right direction or in the left direction, the linear portion LL extending from the quadrant portion QC or the semicircular portion HC in the upper left diagonal direction and the lower right diagonal direction, and the semicircular portion HC extending from the linear portion LL and having a convex arc portion facing in the upper left diagonal direction and the lower right diagonal direction.

In the display devices 900, 1000, 1100, and 1200 according to various exemplary embodiments of the present disclosure, the plurality of line units LU including the plurality of first line patterns 122 and the plurality of connection lines 180 are configured with the plurality of linear portions LU, the plurality of semicircular portions HC, and/or the plurality of quadrant portions QC, so that a length of deformation sections compared to a length of the overall line unit LU of the plurality of line units LU is increased. Thus, the stress of the line units LU may be reduced and the stretching rate may be increased during stretching. When the display devices 900, 1000, 1100, and 1200 are stretched, the line units LU may be stretched as deformation occurs mainly in the semicircular portions HC and the quadrant portions QC of the line units LU. Accordingly, as a length of the plurality of semicircular portions HC and the plurality of quadrant portions QC in an overall length of one line unit LU increases, the line unit LU may be easily stretched. At this time, the convex arc portions of the plurality of semicircular portions HC are disposed in the stretching direction or disposed in an inclined direction with respect to the stretching direction so that deformation of the plurality of semicircular portions HC can be dispersed in the linear portions LL or the quadrant portions QC adjacent to the plurality of semicircular portions HC.

In addition, in the display devices 900, 1000, 1100, and 1200 according to various exemplary embodiments of the present disclosure, it is possible to provide spaces in which the first plate patterns 1021 can be extended by using the quadrant portions QC and the linear portions LL of the line units LU. Accordingly, the pixel PX may be easily formed on the first plate pattern by securing the area of the first plate pattern 1021.

Detailed descriptions on this will be provided with reference to simulation results.

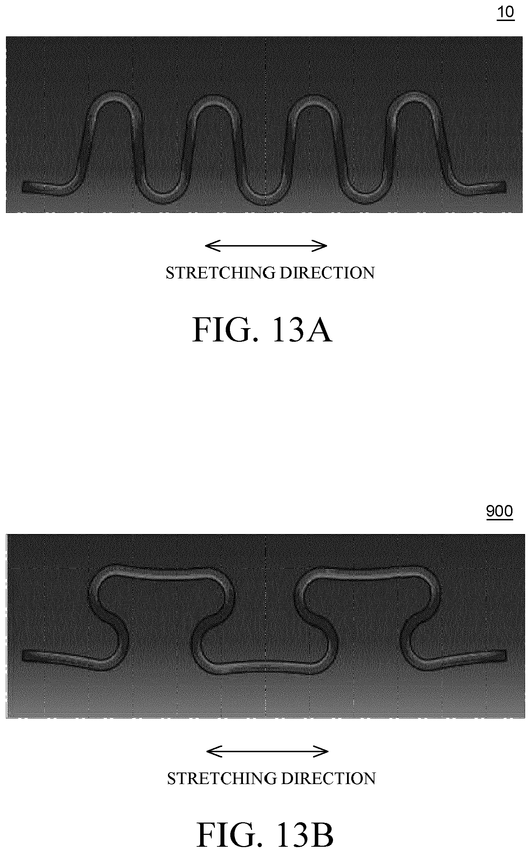

FIGS. 13A and 13B are views illustrating deformation sections of line units when display devices according to Comparative Example and Example of the present disclosure are stretched. FIGS. 13A and 13B are simulation results showing deformation sections of the line units LU when the line units are stretched in a stretching direction. A substantially deformed portion of the line unit LU is a portion indicated in a light color, and a non-deformed portion of the line unit LU is a portion indicated in a dark color.

The line unit LU of a display device 10 according to the Comparative Example has a structure in which a plurality of semicircular portions HC are continuously connected in a portion except for linear portions LL at both ends thereof, and convex arc portions of the semicircular portions HC are disposed in a direction perpendicular to the stretching direction. In addition, the semicircular portion HC having an arc portion facing in one direction and the semicircular portion HC having an arc portion facing in the other direction are alternately disposed.

The display device 900 according to the Example is the display device 900 according to another exemplary embodiment of the present disclosure illustrated in FIG. 9A. The line unit LU of the Example has a structure in which a plurality of semicircular portions HC and a plurality of linear portions LL are alternately disposed, and convex arc portions of the plurality of semicircular portions HC are disposed in the stretching direction.

**Table 1**

| | Comparative Example | Example |
|---|---|---|
| maximum stress | 2440 MPa | 2161 MPa |
| Ratio of overall length of line unit to width of line unit | 2.5 | 2.35 |
| Ratio of length of deformed portion to overall length of line unit | 0.59 | 0.71 |
| maximum stretching rate | 1.8 % | 1.6 % |

First, referring to FIG. 13A and Table 1 together, in the line unit LU of the display device 10 according to the Comparative Example, the semicircular portions HC are disposed in a direction perpendicular to the stretching direction, and the linear portions LL disposed between the plurality of respective semicircular portions HC are disposed in the direction perpendicular to the stretching direction. Accordingly, in the display device 10 according to the Comparative Example, it can be confirmed that stress generated in the semicircular portions HC is not distributed to the linear portions LL, and maximum stress generated in the line unit LU is about 2440 MPa.

On the other hand, referring to FIG. 13B and Table 1 together, in the line unit LU of the display device 900 according to the Example of the present disclosure, ends of the plurality of semicircular portions HC extend in directions perpendicular to the stretching direction, for example, in an upper direction and a lower direction, other than in the stretching direction. In addition, the linear portions LL connected to the both ends of the semicircular portions HC rotate. Accordingly, it can be confirmed that deformation generated in the semicircular portion HC is distributed to the linear portion LL between the semicircular portion HC and the semicircular portions HC and thus, maximum stress of the line unit LU is reduced to about 2161 MPa.

Next, in the line unit LU according to the Comparative Example, a ratio of an overall length of the line unit LU to a width of the line unit LU is about 2.5. That is, the overall length of the line unit LU may be about 2.5 times a shortest linear length from one end to the other end of the line unit LU. That is, since the overall length of the line is long, the line unit LU can be elongated and extended. However, in the line unit LU according to the Comparative Example, although a ratio of an overall length of the line unit LU to a width of the line unit LU is high, deformation mainly occurs only in the semicircular portions HC, so that it can be confirmed that a ratio of a deformation length compared to the overall length of the line unit LU is about 0.59.

Unlike this, in the line unit LU according to the Example of the present disclosure, a ratio of the overall length of the line unit LU to the width of the line unit LU is about 2.35, which is smaller than that of the line unit LU according to Comparative Example. That is, when the line unit LU according to the Comparative Example and the line unit LU according to the Example have the same width, the overall length of the line unit LU according to the Example may be shorter than the overall length of the line unit LU according to the Comparative Example.

However, in the display device 900 according to the Example, since deformation generated in the plurality of semicircular portions HC of the line unit LU is distributed to the linear portions LL around the semicircular portions HC, it can be confirmed that the ratio of the deformation length to the overall length of the line unit LU is about 0.71. Accordingly, although the overall length of the line unit LU of the Example is shorter than that of the line unit LU of Comparative Example, a length of a deformable portion of the line unit LU, that is, a length of a stretchable portion of the line unit LU is greater compared to the case of Comparative Example. Therefore, although the overall length of the line unit LU of the Example is shorter than the overall length of the line unit LU of Comparative Example, since the line unit LU of the Example has a higher percentage of a deformable portion during stretching, it can be confirmed that the line unit LU of the Example has a stretching rate on a similar level, that is, has a stretching rate of 1.6% and 1.8%.

Therefore, in the display devices 900, 1000, 1100, and 1200 according to various exemplary embodiments of the present disclosure, the line units LU can be designed in various shapes by configuring the line unit LU with the plurality of semicircular portions HC, the plurality of quadrant portions QC, and the plurality of linear portions LL. For example, by disposing the plurality of semicircular portions HC in various directions regardless of a stretching direction, stress generated in the plurality of semicircular portions HC during stretching may be dispersed around the plurality of semicircular portions HC, and maximum stress of the line unit LU may be reduced. Accordingly, even if the line unit LU is repeatedly stretched, damage to the line unit LU may be minimized and stretching reliability of the display devices 900, 1000, 1100, and 1200 can be improved. In addition, by increasing a percentage of a deformed portion instead of forming the overall length of the line unit LU long, a stretching rate of the line unit LU can be secured. Accordingly, stretching reliability of the display devices 900, 1000, 1100, and 1200 can be increased by designing shapes of the line units LU variously while floating the line units LU in the filling layer 190.

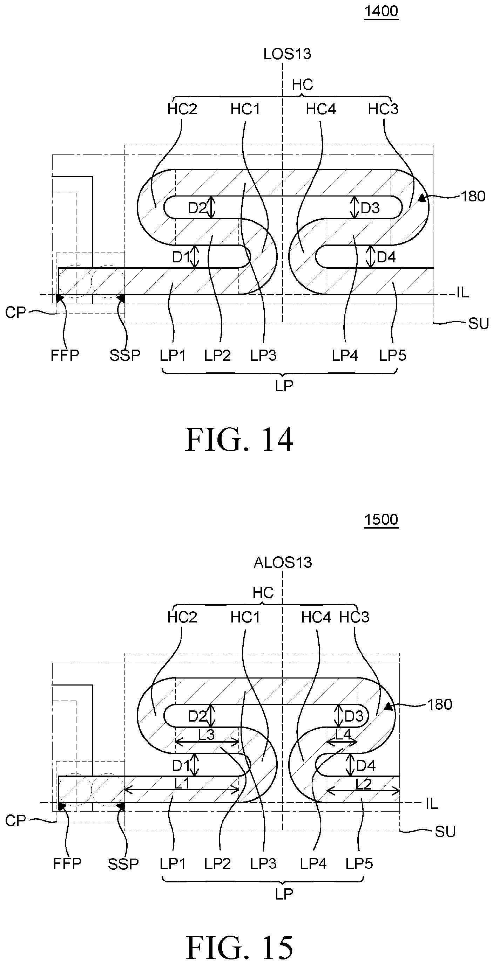

FIGS. 14 to 16 are enlarged plan views of display devices according to various exemplary embodiments of the present disclosure. Other configurations of each of display devices 1400 and 1500 of FIGS. 14 to 16 are substantially identical to those of the display device 100, 900, 1000, 1100, and 1200 of FIGS. 1 to 12 except for differences in terms of shapes of the plurality of first line patterns 122 and the plurality of connection lines 180. Thus, redundant descriptions will be omitted.

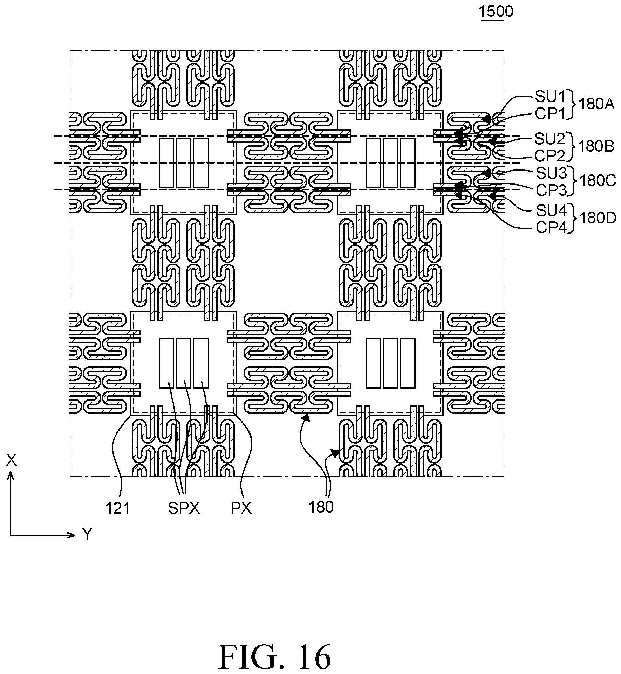

FIG. 14 illustrates a symmetrical layout of the connection line 180 within one stretchable unit SU with respect to a line of symmetry LOS 13. FIG. 15, on the other hand, illustrates an asymmetrical layout of the connection line 180 within one stretchable unit SU with respect to a line of asymmetry ALOS13. FIG. 16 shows a larger view of FIG. 15 having an asymmetrical layout within the stretchable unit SU.

Referring to FIGS. 14 to 16, each of the plurality of connection lines 180 includes at least one stretchable unit SU and a connection portion CP coupled to the at least one stretchable unit SU. The at least one stretchable unit SU may be symmetrical. The at least one stretchable unit SU may be symmetrical with respect to a line of symmetry LOS13. The line of symmetry LOS13 may be oriented parallel to the edge of the plate pattern to which the stretchable unit connects. The line of symmetry LOS13 may bisect the third linear portion LP3 described below. The at least one stretchable unit SU may be bisymmetrical. The at least one stretchable unit SU may be symmetrical in two planes at right angles to each other. In addition to the symmetry with respect to the line of symmetry LOS13, the at least one stretchable unit SU may be symmetrical with respect to a line of symmetry perpendicular to the line of symmetry LOS13, for example may be symmetrical with respect to a line of symmetry oriented perpendicular to the edge of the plate pattern to which the stretchable unit connects. The at least one stretchable unit SU may include a plurality of line portions LP and a plurality of half-ring portions HC. The at least one stretchable unit SU may include an S-shape portion and a reversed S-shape portion comprising the plurality of linear portions LP and the plurality of half-ring portions HC. For example, the at least one stretchable unit SU includes at least 5 linear portions LP. The at least one stretchable unit SU includes at least 4 half-ring portions HC. Each of the half-ring portions HC may be described as a semicircle portion or a semicircle arc portion or a curved portion.

For example, the plurality of linear portions LP may include a first linear portion LP1, a second linear portion LP2, a third linear portion LP3, a fourth linear portion LP4, and a fifth linear portion LP5. The plurality of half-ring portions HC includes a first half-ring portion HC1, a second half-ring portion HC2, a third half-ring portion HC3, and a fourth half-ring portion HC4.

The first half-ring portion HC1 is between and coupled to the first linear portion LP1 and the second linear portion LP2. The second half-ring portion HC2 is between and coupled to the second linear portion LP2 and the third linear portion LP3. The third half-ring portion HC3 is between and coupled to the third linear portion LP3 and the fourth linear portion LP4. The fourth half-ring portion HC4 is between and coupled to the fourth linear portion LP4 and the fifth linear portion LP5. The first linear portion LP1 is coupled to the connection portion CP. The first linear portion LP1 and the connection portion CP may be continuous and contiguous to each other. The first linear portion LP1 and the first half-ring portion HC1 may be continuous and contiguous to each other and the second linear portion LP2 and the first half-ring portion HC1 may be continuous and contiguous to each other. The second linear portion LP2 and the second half-ring portion HC2 may be continuous and contiguous to each other. The third linear portion LP3 and the second half-ring portion HC2 may be continuous and contiguous to each other. The third linear portion LP3 and the third half-ring portion HC3 may be continuous and contiguous to each other. The fourth linear portion LP4 and the third half-ring portion HC3 may be continuous and contiguous to each other. The fourth linear portion LP4 and the fourth half-ring portion HC4 may be continuous and contiguous to each other. The fifth linear portion LP5 and the fourth half-ring portion HC4 may be continuous and contiguous to each other.

The first, second, and third linear portions LP1, LP2 and LP3 overlap with each other and the first, second, and third linear portions LP1, LP2 and LP3 and the first and second half-ring portions HC1 and HC2 form an S-shape. The third, fourth, and fifth linear portions LP3, LP4 and LP5 overlap with each other and the third, fourth, and fifth linear portions LP3, LP4 and LP5 and the third and fourth half-ring portions HC3 and HC4 form a reversed S-shape.

Referring to FIG. 14, the at least one stretchable unit SU may form a symmetrical structure with respect to a line of symmetry LOS13. For example, the first half-ring portion HC1 and the fourth half-ring portion HC4 may be symmetrical with respect to the line of symmetry LOS13, the second half-ring portion HC2 and the third half-ring portion HC3 may be symmetrical with respect to the line of symmetry LOS13, the first linear portion LP1 and the fifth linear portion LP5 may be symmetrical with respect to the line of symmetry LOS13, and the second linear portion LP2 and the fourth linear portion LP4 may be symmetrical with respect to the line of symmetry LOS13.

Referring to FIG. 15, the at least one stretchable unit SU may form an asymmetrical structure with respect to the line of asymmetry ALOS13. For example, the first half-ring portion HC1 and the fourth half-ring portion HC4 may be asymmetrical with respect to the line of asymmetry ALOS13, and the second linear portion LP2 and the third linear portion LP3 may be asymmetrical with respect to the line of asymmetry ALOS13.

Referring to FIGS. 14 and 15, the length of the third linear portion LP3 may be longer than the lengths of the second linear portion LP2 and the length of the fourth linear portion LP4. The length of the first linear portion LP1 may be longer than the lengths of the second linear portion LP2 and the length of the fourth linear portion LP4. If the stretchable unit SU has a symmetrical structure with respect to the line of symmetry LOS13 as shown in FIG. 14, the second and fourth linear portions LP2 and LP4 may have the same length, and the first and fifth linear portions LP1 and LP5 may have the same length. If the stretchable unit SU has an asymmetrical structure with respect to the line of asymmetry ALOS13 as shown in FIG. 15, the lengths of the second and fourth linear portions LP2 and LP4 may be different from each other, and the lengths of the first and fifth linear portions LP1 and LP5 may be different from each other. In particular, a length L1 of the first linear portion LP1 may be longer than a length L2 of the fifth linear portion LP5. Further, a length L3 of the second linear portion LP2 may be longer than a length L4 of the fourth linear portion LP4.

The distance D1 between the first and second linear portions LP1 and LP2 may be the same as the distance D2 between the second and third linear portions LP2 and LP3, the distance D3 between the third and fourth linear portions LP3 and LP4, and the distance D4 between the fourth and fifth linear portions LP4 and LP5. In this case, the sizes of the plurality of half-ring portions HC may be the same.

The connection portion CP may include a first point FFP coupled to the plate pattern 121 and a second point SSP that is between the first point FFP of connection portion CP and the first linear portion LP1 of the at least one stretchable unit SU. The second point SSP is a point that is at the boundary between the connection portion CP and the stretchable unit SU. The first point FFP and the second point SSP may be disposed along an imaginary line IL. That is, the first point FFP and the second point SSP may be connected to each other on the imaginary line IL. The first point FFP and the second point SSP may be continuously connected along the imaginary line IL.

The connection portion CP is coupled to the stretchable unit SU. The connection portion CP may be coupled to the first linear portion LP1 of the stretchable unit SU. The second point SSP may be coupled to the first linear portion LP1. The second point SSP of the connection portion CP and the first linear portion LP1 may be continuous and contiguous to each other.

As shown in FIGS. 14 and 15, none of the portion of the at least one stretchable unit SU may extend below the imaginary line IL that connects between the first point FFP and the second point SSP. For example, the first linear portion LP1 and the fifth linear portion LP5 may abut the imaginary line IL and may be disposed along the imaginary line IL. Accordingly, the first and fifth linear portion LP1 and LP5, the first point FFP, and the second point SSP may be disposed on the same line along the imaginary line IL and these portions extend below the imaginary line IL.

Referring to FIGS. 9A and 16, the plurality of connections lines 180 may include a first connection line 180A and a second connection line 180B adjacent to the first connection line 180A. Further, the plurality of connections lines 180 may include a third connection line180C and a fourth connection line 180D adjacent to the third connection line 180C. The first connection line 180A includes a first stretchable unit SU1 and a first connection portion CP1 and the second connection line 180B includes a second stretchable unit SU2 and a second connection portion CP2. The third connection line 180C includes a third stretchable unit SU3 and a third connection portion CP3 and the fourth connection line 180D includes a fourth stretchable unit SU4 and a fourth connection portion CP4.

The first stretchable unit SU1 and the first connection portion CP1 of the first connection line 180A is symmetric with the second stretchable unit SU2 and the second connection portion CP2 of the second connection line 180B with respect to a first imaginary symmetric line IL1 between the first connection line 180A and the second connection line 180B. The third stretchable unit SU3 and the third connection portion CP3 of the third connection line 180C is symmetric with the fourth stretchable unit SU4 and the fourth connection portion CP4 of the fourth connection line 180D with respect to a second imaginary symmetric line IL2 between the third connection line 180C and the fourth connection line 180D. The first and second connection lines 180A and 180B are symmetric with the third and fourth connection lines 180C and 180D with respect to a third imaginary symmetric line IL3 between the second connection line 180B and the third connection line 180C. However, as described in connection with FIG. 15, each of the stretchable unit SU includes an asymmetrical layout with respect to the line of asymmetry ALOS13.

The exemplary embodiments of the present disclosure can also be described as follows:
According to an aspect of the present disclosure, there is provided a display device. The display device includes a lower substrate that is stretchable and includes an active area and a non-active area, a first adhesive layer disposed on the lower substrate, a pattern layer disposed on the first adhesive layer and including a plurality of first plate patterns and a plurality of first line patterns overlapping the active area, a plurality of sub-pixels disposed on each of the plurality of first plate patterns, a plurality of connection lines disposed on each of the plurality of first line patterns, and a filling layer including a first filling layer filled in the active area and covering the pattern layer, the plurality of sub-pixels, and the plurality of connection lines. The plurality of first line patterns include grooves disposed in lower portions thereof, so that the first adhesive layer and the plurality of first line patterns are spaced apart from each other.

The filling layer may further include a second filling layer filled in the grooves and disposed between the first adhesive layer and the plurality of first line patterns.

The filling layer may be formed of a non-conductive liquid material.

The filling layer may be formed of any one of a silicone polymer such as ecoflex or the like and polydimethylsiloxane (PDMS) that does not contain silicone oil or a curing agent.

The first filling layer and the second filling layer may be disposed to surround the plurality of first line patterns and the plurality of connection lines, and the plurality of first line patterns and the plurality of connection lines may be configured to float in the filling layer.

The display device may further include a second adhesive layer disposed on the filling layer, and an upper substrate disposed on the second adhesive layer, and the first adhesive layer and the second adhesive layer may be bonded to each other in the non-active area to seal the active area filled with the filling layer.

The second adhesive layer may contact at least a portion of the plurality of sub-pixels and is spaced apart from the plurality of connection lines.

According to another aspect of the present disclosure, there is provided a display device. The display device includes a lower substrate that is stretchable and includes an active area and a non-active area, a plurality of first plate patterns disposed on the lower substrate and overlapping the active area, a plurality of sub-pixels disposed on each of the plurality of first plate patterns, and a plurality of line units disposed between the plurality of first plate patterns. The plurality of line units include a plurality of linear portions formed in a linear shape and a plurality of semicircular portions formed in a semicircular shape.

The plurality of line units may include a plurality of first line patterns disposed on the lower substrate and connecting the plurality of first plate patterns to each other, and a plurality of connection lines disposed on the plurality of first line patterns and electrically connected to the plurality of sub-pixels.

An arc portion of each of the plurality of semicircular portions may be disposed in the same direction as a stretching direction of the plurality of line units.

Arc portions of the plurality of semicircular portions of line units extending in a first direction among the plurality of line units may be disposed in the first direction, and arc portions of the plurality of semicircular portions of line units extending in a second direction perpendicular to the first direction among the plurality of line units may be disposed in the second direction.

The arc portions of some semicircular portions among the plurality of semicircular portions may be disposed to face each other.

The arc portion of each of the plurality of semicircular portions may be disposed in an inclined direction with respect to a stretching direction of the plurality of line units.

Arc portions of the plurality of semicircular portions of line units extending in a first direction and line units extending in a second direction perpendicular to the first direction among the plurality of line units may be disposed in directions different from the first direction and the second direction.

The plurality of linear portions and the plurality of semicircular portions may be alternately connected in each of the plurality of line units.

Each of the plurality of semicircular portions may be connected to one of the plurality of linear portions and the plurality of semicircular portions in each of the plurality of line units.

The plurality of line units may further include a plurality of quadrant portions configured in a quadrant shape, and each of the plurality of quadrant portions may be connected to any one of the plurality of linear portions, the plurality of semicircular portions, and the plurality of quadrant portions.

In each of the plurality of line units, one of the plurality of quadrant portions and the plurality of semicircular portions may be connected between the plurality of respective linear portions.

One quadrant portion of the plurality of quadrant portions may be disposed between the plurality of linear portions to form a vertical structure, and at least a portion of the plurality of first plate patterns may extend toward the vertical structure.

Line units extending in a first direction among the plurality of line units may include five or more of the plurality of linear portions and four or more of the plurality of semicircular.

Each of the plurality of linear portions included in at least some of the plurality of line units may have a length longer that a radius of each of the plurality of semicircular portions.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure.

The various embodiments described above can be combined to provide further embodiments. All of the U.S. patents, U.S. patent application publications, U.S. patent applications, foreign patents, foreign patent applications and non-patent publications referred to in this specification and/or listed in the Application Data Sheet are incorporated herein by reference, in their entirety. Aspects of the embodiments can be modified, if necessary to employ concepts of the various patents, applications and publications to provide yet further embodiments.

These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

The disclosure comprises the following items:
1. A display device, comprising:
   a lower substrate that is stretchable and includes an active area and a non-active area;
   a first adhesive layer disposed on the lower substrate;
   a pattern layer disposed on the first adhesive layer and including a plurality of first plate patterns and a plurality of first line patterns overlapping the active area;
   a plurality of sub-pixels disposed on each of the plurality of first plate patterns;
   a plurality of connection lines disposed on each of the plurality of first line patterns;
   a filling layer including a first filling layer filled in the active area and covering the pattern layer, the plurality of sub-pixels, and the plurality of connection lines; and
   grooves disposed in lower portions of the plurality of first line patterns,
   wherein the first adhesive layer and the plurality of first line patterns are spaced apart from each other through the grooves.
2. The display device of item 1, wherein the filling layer further includes a second filling layer filled in the grooves and disposed between the first adhesive layer and the plurality of first line patterns.
3. The display device of item 1 or item 2, wherein the filling layer is formed of a non-conductive liquid material.
4. The display device of any preceding item, wherein the filling layer is formed of any one of a silicone polymer and polydimethylsiloxane (PDMS) that does not contain silicone oil or a curing agent.
5. The display device of any preceding item, wherein the first filling layer and the second filling layer are disposed to surround the plurality of first line patterns and the plurality of connection lines, and
   wherein the plurality of first line patterns and the plurality of connection lines are configured to float in the filling layer.
6. The display device of any preceding item, further comprising:
   a second adhesive layer disposed on the filling layer; and
   an upper substrate disposed on the second adhesive layer,
   wherein the first adhesive layer and the second adhesive layer are bonded to each other in the non-active area to seal the active area filled with the filling layer.
7. The display device of any preceding item, wherein the second adhesive layer contacts at least a portion of the plurality of sub-pixels and is spaced apart from the plurality of connection lines.
8. A display device, comprising:
   a lower substrate that is stretchable and includes an active area and a non-active area;
   a plurality of first plate patterns disposed on the lower substrate and overlapping the active area;
   a plurality of sub-pixels disposed on each of the plurality of first plate patterns; and
   a plurality of line units disposed between adjacent first plate patterns of the plurality of first plate patterns,
   wherein the plurality of line units include a plurality of linear portions and a plurality of semicircular portions.
9. The display device of item 8, wherein the plurality of line units include,
   a plurality of first line patterns disposed on the lower substrate and coupling the plurality of first plate patterns to each other; and
   a plurality of connection lines disposed on the plurality of first line patterns and electrically connected to the plurality of sub-pixels.
10. The display device of item 8 or item 9, wherein an arc portion of each of the plurality of semicircular portions is disposed in a same direction as a stretching direction of the plurality of line units.
11. The display device of any of items 8-10, wherein arc portions of the plurality of semicircular portions of line units extending in a first direction among the plurality of line units are disposed in the first direction, and
   wherein arc portions of the plurality of semicircular portions of line units extending in a second direction perpendicular to the first direction among the plurality of line units are disposed in the second direction.
12. The display device of any of items 8-11, wherein the arc portions of some semicircular portions among the plurality of semicircular portions are disposed to face each other.
13. The display device of any of items 8-12, wherein the arc portion of each of the plurality of semicircular portions is disposed in an inclined direction with respect to a stretching direction of the plurality of line units.
14. The display device of any of items 8-13, wherein arc portions of the plurality of semicircular portions of line units extending in a first direction and line units extending in a second direction perpendicular to the first direction among the plurality of line units are disposed in directions different from the first direction and the second direction.
15. The display device of any of items 8-14, wherein the plurality of linear portions and the plurality of semicircular portions are alternately coupled in each of the plurality of line units.
16. The display device of any of items 8-15, wherein each of the plurality of semicircular portions is coupled to one of the plurality of linear portions and the plurality of semicircular portions in each of the plurality of line units.
17. The display device of any of items 8-16, wherein the plurality of line units further include a plurality of quadrant portions configured in a quadrant shape,
   wherein each of the plurality of quadrant portions is coupled to any one of the plurality of linear portions, the plurality of semicircular portions, and the plurality of quadrant portions.
18. The display device of any of items 8-17, wherein in each of the plurality of line units, one of the plurality of quadrant portions and the plurality of semicircular portions are coupled between the plurality of respective linear portions.
19. The display device of any of items 8-18, wherein one quadrant portion of the plurality of quadrant portions is disposed between the plurality of linear portions to form a vertical structure,
   wherein at least a portion of the plurality of first plate patterns extends toward the vertical structure.
20. The display device of any of items 8-19, wherein line units extending in a first direction among the plurality of line units includes five or more of the plurality of linear portions and four or more of the plurality of semicircular.
21. The display device of any of items 8-20, wherein each of the plurality of linear portions included in at least some of the plurality of line units has a length longer that a radius of each of the plurality of semicircular portions.
22. A display device, comprising:
   a stretchable lower substrate having thereon an active area and a non-active area adjacent to the active area;
   a plurality of plate patterns on the lower substrate and overlapping the active area;
   a plurality of connections lines coupled between adjacent plate patterns of the plurality of plate patterns, each connection line of the plurality of connections lines include:
      at least one stretchable unit; and
      a connection portion coupled to the at least one stretchable unit,
   wherein the at least one stretchable unit includes:
      a plurality of linear portions; and
      a plurality of half-ring shaped portions;
   wherein the at least one stretchable unit is bisymmetrical.
23. The display device of item 22, wherein the at least one stretchable unit includes at least 5 linear portions.
24. The display device of item 22 or item 23, wherein the at least one stretchable unit includes at least 4 half-ring portions.
25. The display device of any of items 22-24, wherein the plurality of linear portions includes a first linear portion, a second linear portion, a third linear portion, a fourth linear portion, and a fifth linear portion,
   wherein the plurality of half-ring shaped portions includes a first half-ring portion, a second half-ring portion, a third half-ring portion, and a fourth half-ring portion,
   wherein the first half-ring portion is between and coupled to the first linear portion and the second linear portion,
   wherein the second half-ring portion is between and coupled to the second linear portion and the third linear portion,
   wherein the third half-ring portion is between and coupled to the third linear portion and the fourth linear portion, and
   wherein the fourth half-ring portion is between and coupled to the fourth linear portion and the fifth linear portion.
26. The display device of any of items 22-25, wherein the first, second, and third linear portions overlap with each other.
27. The display device of any of items 22-26, wherein the third, fourth, and fifth linear portions overlap with each other.
28. The display device of any of items 22-27, wherein the first, second, and third linear portions and the first, second half-ring portions form an S-shape.
29. The display device of any of items 22-28, wherein the third, fourth, and fifth linear portions and the third, fourth half-ring portions form a reversed S-shape.
30. The display device of any of items 22-29, wherein the first linear portion is coupled to the connection portion,
   wherein the first linear portion and the connection portion are continuous and contiguous to each other,
   wherein the first linear portion and the first half-ring shape portion are continuous and contiguous to each other,
   wherein the second linear portion and the first half-ring shape portion are continuous and contiguous to each other,
   wherein the second linear portion and the second half-ring shape portion are continuous and contiguous to each other,
   wherein the third linear portion and the second half-ring shape portion are continuous and contiguous to each other,
   wherein the third linear portion and the third half-ring shape portion are continuous and contiguous to each other,
   wherein the fourth linear portion and the third half-ring shape portion are continuous and contiguous to each other, and
   wherein the fifth linear portion and the fourth half-ring shape portion are continuous and contiguous to each other.
31. The display device of any of items 22-30, wherein the connection portion includes a first point coupled to a plate pattern of the adjacent plate patterns and a second point that is between the connection portion and the first linear portion,
   wherein none of the portion of the at least one stretchable unit extends below an imaginary extended line that connects between the first point and the second point.
32. The display device of any of items 22-31, wherein the first linear portion and the fifth linear portion abuts the imaginary extended line.
33. The display device of any of items 22-32, wherein the plurality of connections lines includes a first connection line and a second connection line adjacent to the first connection line,
   wherein the first connection line includes a first stretchable unit and a first connection portion,
   wherein the second connection line includes a second stretchable unit and a second connection portion,
   wherein the first stretchable unit and the first connection portion of the first connection line is symmetric with the second stretchable unit and the second connection portion of the second connection line with respect to a first imaginary symmetric line between the first connection line and the second connection line.
34. The display device of any of items 22-33, wherein the plurality of connections lines includes a third connection line and a fourth connection line adjacent to the third connection line,
   wherein the third connection line includes a third stretchable unit and a third connection portion,
   wherein the fourth connection line includes a fourth stretchable unit and a fourth connection portion,
   wherein the third stretchable unit and the third connection portion of the third connection line is symmetric with the fourth stretchable unit and the fourth connection portion of the fourth connection line with respect to a second imaginary symmetric line between the third connection line and the fourth connection line, and
   wherein first and second connection lines are symmetric with the third and fourth connection lines with respect to a third imaginary symmetric line between the second connection line and the third connection line.
35. A display device, comprising:
   a stretchable lower substrate having thereon an active area and a non-active area adjacent to the active area;
   a plurality of plate patterns on the lower substrate and overlapping the active area;
   a plurality of connections lines coupled between adjacent plate patterns of the plurality of plate patterns, each connection line of the plurality of connections lines include:
      at least one stretchable unit; and
      a connection portion coupled to the at least one stretchable unit,
   wherein the at least one stretchable unit includes:
      a plurality of linear portions; and
      a plurality of half-ring shaped portions;
   wherein the at least one stretchable unit includes an S-shape portion and a reversed S-shape portion comprising the plurality of linear portions and the plurality of half-ring shaped portions.
36. The display device of item 35, wherein the at least one stretchable unit includes at least 5 linear portions, and wherein the at least one stretchable unit includes at least 4 half-ring portions.

## Claims

1. A display device, comprising:
a stretchable lower substrate having thereon an active area and a non-active area adjacent to the active area;
a plurality of plate patterns on the lower substrate and overlapping the active area;
a plurality of connection lines coupled between adjacent plate patterns of the plurality of plate patterns, each connection line of the plurality of connection lines including a respective instance of:
at least one stretchable unit; and
a connection portion coupled to the at least one stretchable unit,
wherein the at least one stretchable unit includes:
a plurality of linear portions; and
a plurality of half-ring shaped portions;
wherein the at least one stretchable unit is bisymmetrical.

2. The display device of claim 1, wherein the at least one stretchable unit includes at least 5 linear portions.

3. The display device of claim 1 or claim 2, wherein the at least one stretchable unit includes at least 4 half-ring portions.

4. The display device of claim 1, wherein the plurality of linear portions includes a first linear portion, a second linear portion, a third linear portion, a fourth linear portion, and a fifth linear portion,
wherein the plurality of half-ring shaped portions includes a first half-ring portion, a second half-ring portion, a third half-ring portion, and a fourth half-ring portion,
wherein the first half-ring portion is between and coupled to the first linear portion and the second linear portion,
wherein the second half-ring portion is between and coupled to the second linear portion and the third linear portion,
wherein the third half-ring portion is between and coupled to the third linear portion and the fourth linear portion, and
wherein the fourth half-ring portion is between and coupled to the fourth linear portion and the fifth linear portion.

5. The display device of claim 4, wherein the first, second, and third linear portions are parallel to each other.

6. The display device of claim 4 or claim 5, wherein the third, fourth, and fifth linear portions are parallel to each other.

7. The display device of any of claims 4-6, wherein the first, second, and third linear portions and the first and second half-ring portions form an S-shape.

8. The display device of any of claims 4-7, wherein the third, fourth, and fifth linear portions and the third and fourth half-ring portions form a reversed S-shape.

9. The display device of any of claims 4-8, wherein the first linear portion is coupled to the connection portion,
wherein the first linear portion and the connection portion are continuous and contiguous to each other,
wherein the first linear portion and the first half-ring shape portion are continuous and contiguous to each other,
wherein the second linear portion and the first half-ring shape portion are continuous and contiguous to each other,
wherein the second linear portion and the second half-ring shape portion are continuous and contiguous to each other,
wherein the third linear portion and the second half-ring shape portion are continuous and contiguous to each other,
wherein the third linear portion and the third half-ring shape portion are continuous and contiguous to each other,
wherein the fourth linear portion and the third half-ring shape portion are continuous and contiguous to each other,
wherein the fourth linear portion and the fourth half-ring shape portion are continuous and contiguous to each other, and
wherein the fifth linear portion and the fourth half-ring shape portion are continuous and contiguous to each other.

10. The display device of any of claims 4-9, wherein the connection portion includes a first point coupled to a plate pattern of the adjacent plate patterns and a second point that is between the connection portion and the first linear portion,
wherein none of the portion of the at least one stretchable unit extends below an imaginary extended line that connects between the first point and the second point.

11. The display device of claim 10, wherein the first linear portion and the fifth linear portion abut or overlap the imaginary extended line.

12. The display device of any preceding claim, wherein the plurality of connection lines includes a first connection line and a second connection line adjacent to the first connection line,
wherein the first connection line includes a first stretchable unit and a first connection portion,
wherein the second connection line includes a second stretchable unit and a second connection portion,
wherein the first stretchable unit and the first connection portion of the first connection line is symmetric with the second stretchable unit and the second connection portion of the second connection line with respect to a first imaginary symmetric line between the first connection line and the second connection line.

13. The display device of claim 12, wherein the plurality of connection lines includes a third connection line and a fourth connection line adjacent to the third connection line,
wherein the third connection line includes a third stretchable unit and a third connection portion,
wherein the fourth connection line includes a fourth stretchable unit and a fourth connection portion,
wherein the third stretchable unit and the third connection portion of the third connection line is symmetric with the fourth stretchable unit and the fourth connection portion of the fourth connection line with respect to a second imaginary symmetric line between the third connection line and the fourth connection line, and
wherein the first and second connection lines are symmetric with the third and fourth connection lines with respect to a third imaginary symmetric line between the second connection line and the third connection line.

14. The display device of any preceding claim, comprising:
a first adhesive layer disposed on the stretchable lower substrate;
a pattern layer disposed on the first adhesive layer and including the plurality of plate patterns and a plurality of first line patterns overlapping the active area;
a plurality of sub-pixels disposed on the plurality of plate patterns;
the plurality of connection lines disposed on the plurality of first line patterns;
a filling layer including a first filling layer filled in the active area and covering the pattern layer, the plurality of sub-pixels, and the plurality of connection lines; and
grooves disposed in lower portions of the plurality of first line patterns and configured to space apart the first adhesive layer from the plurality of first line patterns.

15. The display device of claim 14, wherein the filling layer further includes a second filling layer filled in the grooves and disposed between the first adhesive layer and the plurality of first line patterns.

16. The display device of claim 14 or claim 15, wherein the filling layer is formed of a non-conductive liquid material.

17. The display device of any of claims 14-16, wherein the filling layer is formed of any one of a silicone polymer and polydimethylsiloxane (PDMS) that does not contain silicone oil or a curing agent.

18. The display device of any of claims 14-17, wherein the first filling layer and the second filling layer are disposed to surround the plurality of first line patterns and the plurality of connection lines, and
wherein the plurality of first line patterns and the plurality of connection lines are configured to float in the filling layer.

19. The display device of any of claims 14-18, further comprising:
a second adhesive layer disposed on the filling layer; and
an upper substrate disposed on the second adhesive layer,
wherein the first adhesive layer and the second adhesive layer are bonded to each other in the non-active area to seal the active area filled with the filling layer.

20. The display device of claim 19, wherein the second adhesive layer contacts at least a portion of the plurality of sub-pixels and is spaced apart from the plurality of connection lines.
